(19) Europäisches Patentamt
European Patent Office
Office européen des brevets

(11) EP 4 043 962 B1

(12) **EUROPÄISCHE PATENTSCHRIFT**

(45) Veröffentlichungstag und Bekanntmachung des Hinweises auf die Patenterteilung:
**07.06.2023 Patentblatt 2023/23**

(21) Anmeldenummer: **21156660.9**

(22) Anmeldetag: **11.02.2021**

(51) Internationale Patentklassifikation (IPC):
***G03F 7/027*** *(2006.01)* ***C08F 2/50*** *(2006.01)*

(52) Gemeinsame Patentklassifikation (CPC):
**G03F 7/001; C08F 2/50; G03F 7/027; G03F 7/032; G03F 7/033; G03F 7/038;** G02B 5/32; G03F 7/105; G03H 2260/12

# (54) PHOTOPOLYMERISIERBARE ZUSAMMENSETZUNG

PHOTOPOLYMERIZABLE COMPOSITION

COMPOSITION PHOTOPOLYMÉRISABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.08.2022 Patentblatt 2022/33**

(73) Patentinhaber: **Xetos AG**
**85662 Hohenbrunn (DE)**

(72) Erfinder: **KNOCKE, Frank**
**85560 Ebersberg (DE)**

(74) Vertreter: **Gerauer, Marc Philippé**
**Kraus & Weisert**
**Patentanwälte PartGmbB**
**Thomas-Wimmer-Ring 15**
**80539 München (DE)**

(56) Entgegenhaltungen:
**US-A1- 2007 187 947** **US-A1- 2010 112 458**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 043 962 B1

## Beschreibung

### Gebiet der Erfindung

Die vorliegende Erfindung bezieht sich auf photopolymerisierbare Zusammensetzungen und daraus hergestellte Elemente sowie deren Verwendung. Die photopolymerisierbaren Zusammensetzungen eignen sich insbesondere als Aufzeichnungsmaterial für optische Elemente mit Brechungsindexmodulation, insbesondere Hologramme.

Es ist eine Vielzahl von Hologrammen wie Reflexionshologramme, Prägehologramme oder Transmissionshologramme oder Volumenhologramme bekannt.

Ein Volumenhologramm wird beispielsweise dadurch hergestellt, indem zwei Lichtwellen gleicher Wellenlänge, auch Objekt- und Referenzstrahl genannt, zur Interferenz gebracht und ein holographisches Aufzeichnungmedium, in der Regel ein photographischer Film, mit dem entstehenden Interferenzmuster, das i.d.R. ein Intensitätsmuster ist, belichtet wird. Der holographische Belichtungsprozess und die Vervielfältigung des Hologramms (Replikation) sind technisch komplexe optische Verfahren, die spezielle anwendungstechnische Kenntnisse erfordern. Methoden zur Erzeugung von Hologrammen und die Theorie sind in der Literatur umfassend beschrieben [Howard M. Smith, "Principles of Holography", Wiley (1969)] [Fred Unterseher, et al. "Holography Handbook: Making Holograms the Easy Way", Ross Books (1982)] [Graham Saxby, "Practical Holography", Inst, of Physics Pub. (2004)].

Bekannte Aufzeichungsmaterialien mit unterschiedlichem Eigenschaftsprofil und Anwendungsgebiet sind: Silberhalogenid-Emulsionen, gehärtete Dichromat-Gelatine, ferroelektrische Kristalle, photochrome und dichroide Materialien sowie Photopolymere [Howard M. Smith, "Principles of Holography", Wiley (1969).]. Für Anwendungen mit hohen Stückzahlen sind solche Materialien von Interesse, die problemlos in den Anlagen zur Hologrammherstellung und -Vervielfältigung integriert werden können und die eine einfache holographische Belichtung und Entwicklung ermöglichen. Photopolymere gelten aufgrund ihrer hohen Effizienz, ihrer einfachen Handhabung und ihrer guten Lagerstabilität als besonders bevorzugt. Die bekanntesten Photopolymere stammen von DuPont, z.B. Omnidex HRF 600 [S. M. Schultz, et al. "Volume grating preferential-order focusing waveguide coupler," Opt. Lett., vol. 24, pp. 1708-1710, Dec. 1999.] Omnidex-Materialien gehört zu der Klasse der sich selbstentwickelnden Photopolymerfilme basierend auf radikalischer Polymerisation und Monomerdiffusion (siehe EP 0 324 480 A2).

Omnidex-Photopolymere wurden im Laufe der Jahre weiterentwickelt, primär mit dem Ziel, den Brechungsindexkontrast zu erhöhen und im Film einen hohen Beugungswirkungsgrad zu erzielen (siehe US 49421 12 A und DE 69032682 T2). Dennoch werden die anwendungstechnisch relevanten Beugungswirkungsgrade von deutlich über 2/3 durch einen hohen Anteil an thermoplastischem Binder erkauft.

Bei der Filmherstellung muss der Binder für die Beschichtung flüssig sein. Dazu wird ein Lösemittel eingesetzt, dessen Abdampfen nach der Beschichtung zu einer starken Abnahme der Schichtdicke führt. Die aufzutragende Nassschicht ist daher entsprechend dem Lösemittelanteil wesentlich dicker als die resultierende Filmschicht. Der Lösemittelanteil beträgt i.d.R. etwa 80%. Um eine volumenholographisch belichtbare Schicht von 20μm zu erreichen, muss in diesem Fall eine Nassschicht von 100μm aufgetragen werden. Die erforderliche hohe Dicke der Nassschicht verhindert oder erschwert die Verwendung von bekannten Druckverfahren, wie Flexo- oder Tiefdruck. Beim Siebdruck kann es bei der Verwendung von schnell trocknenden Lösungsmitteln zu einer Verklebung des Netzes kommen.

Der Film kann zudem erst weiter verarbeitet bzw. aufgewickelt werden, wenn das gesamte Lösemittel abgedampft ist. In der Produktion muss daher eine lange Trocknungsstrecke mit einer gesundheits- und umweltgerechten Absaugung, sowie einer staub- und explosionsgeschützter Umgebung aufgebaut werden. Dieser Aufwand führt dazu, dass die Filmherstellung und die holographische Belichtung i.d.R. an getrennten Orten und Zeiten stattfindet.

Bei den binderhaltigen Materialien ist zudem eine thermische Nachbehandlung ("Tempern") des belichteten und UV-fixierten Photopolymeren nötig, um den maximalen Brechungsindexkontrast zu erzielen (siehe DE 68905610 T2). Das Tempern ist ein zusätzlicher zeitaufwendiger Verarbeitungsschritt, der die Hologrammherstellung neben der aufwendigen Filmherstellung verlangsamt, verkompliziert und verteuert und zudem die Wahl der Trägermaterialien auf nicht temperaturempfindliche einschränkt.

Andere Photopolymer-Materialien für die Volumenholographie wurden von Polaroid (siehe US 5759721 A), Fuji Photo Film (siehe EP 1 510 862 A2), Konica Minolta Medical & Graphic (siehe US 200505891 A1), Dai Nippon Printing (siehe EP 123151 A1), Nippon Paint (siehe EP 21 1615 A2), Nissan Chemical Industries (siehe US 20050068594 A1), Bayer (siehe WO 2010091795 A1, WO 2012062655 A2), Xetos (siehe WO 2003036389 A1) und InPhase Technologies (siehe US 2002142227 A1) entwickelt. Der Stand der Technik weist Photopolymere aus, die sich durch ihre holographischen Eigenschaften oder ihre Verarbeitung von Omnidex unterscheiden. Der technische Fortschritt wird durch verringerte Sauerstoffempfindlichkeit dokumentiert, reduzierten Materialschrumpf während der Belichtung, angepasste spektrale Empfindlichkeit (Sensitivität), lösemittelfreie Filmherstellung, höheren Beugungswirkungsgrad ohne Tempern und/oder bessere Temperatur- und Lagerstabilität.

Ein neueres und kommerziell erhältliches holographisches Photopolymer ist das von Bayer Materialscience entwickelte "Bayfol HX"-Film. Dieser enthält als Polymermatrix, welche die holographisch belichtbaren Schreibmonomere

aufnimmt, keinen thermoplastischen Binder, sondern ein Polyurethan. Das Polyurethan entsteht durch Polyaddition aus einem Polyisocyanat und Polyol Gemisch. Die reaktiven Komponenten werden erst kurz vor der Beschichtung zusammengemischt und härten auf der Trägerfolie aus. Ein hoher Lösemittelanteil wie bei den vorher beschriebenen binderhaltigen Materialien ist zwar nicht vorhanden, aber durch die Aushärtungszeit von bis zu einer Stunde besteht die selbe Problematik, eine genügend lange staubfreie Trocknungs- bzw. Härtungsstrecke in der Beschichtungsanlage zur Verfügung zu stellen.

Wie bei allen kommerziell erhältlichen Photopolymerfilmen kann der Anwender das Trägermaterial nicht frei wählen und selber beschichten, sondern muss den gelieferten Folienaufbau verarbeiten. Neben der Trägerfolie befindet sich noch eine Kaschierfolie auf der lichtempfindlichen Filmschicht, um eine Verklebung und Verschmutzung zu vermeiden. Das Abziehen dieser Folie kann eine statische Aufladung bewirken, die Staubpartikel anzieht. Da der Film zur Belichtung entweder auf Glas oder einem Master auflaminiert werden muss, wo jedes Staubteilchen eine Fehlstelle erzeugt, wird für eine saubere und fehlerlose Verarbeitung eine extrem staubfreie Umgebung benötigt.

Photopolymersysteme, die einen polymeren Binder oder polymere Matrix enthalten, bilden eine im Wesentlichen feste Filmschicht. Im Unterschied dazu sind auch Binder-freie Systeme vorgestellt worden, die bis zur Belichtung im Wesentlichen flüssig sind (siehe z.B. US-Patent 3,993,485 A oder N. Smirnova, Optics in Information Systems, February 2004, S. 9 oder Xetos (siehe WO 2003036389 A1).

Bei den meisten im Wesentlichen festen Monomer-Binder/Matrix-Photopolymeren diffundieren nach der holographischen Laserbelichtung nicht belichtete Schreibmonomere, die sich im Bereich der dunklen Interferenzlinien befanden, in die belichteten polymerisierten Bereiche nach. Dadurch entsteht ein Brechungsindexunterschied dessen räumliche Modulation dem aufzuzeichnenden Interferenzmuster entspricht. Die Diffusion der Schreibmonomere in der festen Matrix benötigt allerdings Zeit. Eine Temperaturerhöhung kann diesen Vorgang beschleunigen. DuPont gibt für das genannte OmniDex®-Material eine Temperzeit von einer Stunde bei 120 °C an. Beim Bayfol HX-Material wird in den Patenanmeldungen (EP 2 372 454 A1 S.13 [0127], EP 2 219 073 A1 S.15 [0102]) eine Wartezeit von 5min angegeben bevor das Material mit UV-Licht endgültig komplett gehärtet wird,

Für viele Produktionsverfahren sind aber möglichst geringe Zeiten bzw. ein möglichst hoher Durchsatz und eine einfache, kostengünstige Prozessführung für die Herstellung der Hologramme gefordert, so dass umständliche und zeitintensive Nachbehandlungen oder Wartezeiten von Nachteil sind.

Aus diesem Grund wurden photopolymerisierbare Zusammensetzungen entwickelt, die eine effektive Brechungsindexmodulation schon während der Laserbelichtung ausbilden und sofort mit UV-Licht fixiert werden können, wie dies in der EP 1 779 196 B1 beschrieben wird. Dort wurden verschiedene Triglyceride, wie z.B. Rizinusöl, verwendet.

Das Rizinusöl ist eine inerte Komponente, die beim Belichten nicht vernetzt. Dadurch kann sie später aus der Schicht raus migrieren. Um dies sicher zu verhindern, wird die Hologrammschicht in der Regel nachträglich mit einer UV-LackSchicht versiegelt.

Wenn der Rizinusölanteil allerdings zu hoch ist, dann kann dies schon während oder kurz nach der Belichtung passieren. Auch führt ein zu hoher Anteil zu einer Trübung. Je höher der Rizinusanteil ist, desto höher muss die Belichtungstemperatur sein, um eine klare Schicht zu gewährleisten. Durch die Erhöhung der Temperatur verringert sich aber die Viskosität des Flüssigmaterials, was sich negativ auf die holographische Belichtbarkeit auswirkt. Es gibt daher eine Obergrenze des Rizinusanteils und der Belichtungstemperatur, welche für eine holographische Belichtung nicht überschritten werden darf.

Die Helligkeit bzw. der Beugungswirkungsgrad (BWG) $\eta$ von Volumenhologrammen hängt von deren Schichtdicke d und vom $\Delta n$ ab. $\Delta n$ bezeichnet die Amplitude der Brechungsindexmodulation innerhalb der Hologrammschicht. Nach der Coupled Wave Theorie von Kogelnik (siehe; H. Kogelnik, The Bell System Technical Journal, Volume 48, November 1969, Number 9 Seite 2909 - Seite 2947) gilt, dass je höher der $\Delta n$ Wert ist, desto dünner können die Schichten sein um ein hohen BWG-Wert zu erreichen. Für Reflexionshologramme von Oberflächenspiegeln bzw. Lippmann-Bragg-Hologramme, wo die Brechungsindexmodulation parallel zur Oberfläche verläuft, gilt folgender Zusammenhang

$$\eta = tanh^2(\frac{\pi \cdot \Delta n \cdot d}{\lambda}), \qquad \text{(F-1)}$$

wobei $\lambda$ die Wellenlänge des Lichtes ist.

## Beschreibung der Erfindung

Der vorliegenden Erfindung liegt somit die Aufgabe zugrunde, ein holographisches Aufzeichnungsmaterial bereitzustellen, das die genannten Nachteile bekannter Aufzeichnungsmaterialien vermeidet und insbesondere eine verbesserte und sehr schnelle Verarbeitung ermöglicht. Die aus dem Aufzeichnungsmaterial hergestellten holographischen Elemente sollten außerdem eine möglichst hohe Brechungsindexmodulation sowie eine hohe Langzeitstabilität

als auch eine thermische und mechanische Stabilität aufweisen. Es sollten Δn-Werte von ≥0,01, bevorzugt von ≥ 0,015 und besonders bevorzugt von ≥ 0,02 erreicht werden können.

Die Aufgabe wird erfindungsgemäß gelöst durch eine photopolymerisierbare Zusammensetzung, umfassend:

I) eine erste Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv.

Das Triglycerid bzw. das modifizierte Triglycerid ist eine Komponente, die bei der lichtinduzierten Polymermersierung der Mischung nicht mit vernetzt. Das Gemisch aus mindestens einem Monomer und Triglycerid ergibt bevorzugt erst ab einer bestimmten Temperatur eine klare Mischung. Vorzugsweise sind die erfindungsgemäßen photopolymerisierbaren Zusammensetzungen oberhalb einer Temperatur von 24°C und besonders bevorzugt ab 22°C klar, während sie vorzugsweise unter 16°C und besonders bevorzugt unter 18°C milchig sind. Die Monomermischung aus ein oder mehreren Monomeren, sowie das daraus entstehende Polymer haben einen anderen Brechungsindex als die nicht vernetzende Komponente. Bei der holographischen Belichtung führt eine Entmischung der Komponenten dazu, dass an den dunklen Stellen des Interferenzmuster der Triglyceridanteil höher als in den hellen Bereichen ist. Dadurch wird der Brechungsindex entsprechend moduliert und ein Hologramm erstellt.

Da das Triglycerid bzw. das modifizierte Triglycerid nicht polymerisiert und Trübungen verursachen kann, darf dessen Konzentration nicht zu hoch sein, da sonst kein stabiles und klares Hologramm belichtet werden kann.

Es zeigte sich überraschenderweise aber, dass durch die Zugabe eines bestimmten Aldehyds die Grenze nach oben verschoben werden kann. Dies ist vorteilhaft, weil dadurch ein höherer Delta-n-Wert bzw. ein höherer BWG bei dünneren Schichten erreicht werden kann. Dabei genügt schon eine sehr geringe Menge von diesem Stoff.

Das spätere Ausschwitzen des Rizinusöles kann auch durch Zugabe von Stoffen verhindert werden, welche schneller als das Öl die ausgehärtete Schicht verlassen. Dies können geringe Mengen von Lösemittel wie z.B. Ethanol sein oder Feststoffe, die Sublimieren oder einige UV-Initiatoren. Besonders die UV-Initiatoren können durch einen kurzen intensiven UV-Blitz dazu gebracht werden, durch Verdampfen die Schicht schneller als das Rizinusöl zu verlassen. Die UV-Initiatoren oder andere Absorber können aber auch dazu dienen den Ausstoß anderer Stoffe zu beschleunigen, indem sie die absorbierte Energie in Hitze umwandeln und weitergeben. Im Prinzip können anstatt des UV-Blitzes alle Methoden (Pulslichtlaser, Infrarot, Mikrowellen etc.) verwendet werden, die das Material über passende Absorbersubstanzen schlagartig innerhalb einer sehr kurzen Zeitspanne erhitzen.

Durch die Stoffabgabe schrumpft natürlich die Schicht, welches sich auch in den Hologrammeigenschaften bemerkbar macht. Dies kann beim Belichten entsprechend berücksichtigt oder absichtlich genutzt werden, um z.B. blaue Hologramme mit einem grünen Laser zu erzeugen.

Die erfindungsgemäße photopolymerisierbare Zusammensetzung umfasst vorzugsweise:

I) eine erste Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv,

II) mindestens einen Polyether.

Die unbelichtete photopolymerisierbare Zusammensetzung wird bei niedrigen Temperaturen milchig. Sie kann bestmöglich holographisch bei einer Temperatur belichtet werden, die knapp über dieser Entmischungstemperatur liegt. Bei aus dem Stand der Technik bekannten Mischungen lag die empfohlene Belichtungstemperatur bei 25°-26°C.

Durch die Zugabe von einem Gemisch aus Polyether kann die Belichtungstemperatur vorteilhaft auf eine gängige Raumtemperatur von 21 °-22°C gebracht werden. Zudem wird mit der Zugabe auch eine Verbesserung des Delta-n-Wertes erreicht, so dass schon bei dünneren Schichten ein höherer BWG (Brechungswirkungsgrad) erzielt werden kann. Nun ist schon ab 12 μm ein BWG-Wert von über 80% sicher erreichbar, vorher lag dieser Wert bei 15 μm.

Überraschenderweise zeigte sich zudem, dass die Klarheit der belichteten Schicht davon abhängt mit welcher Belichtungszeit und -intensität belichtet bzw. gehärtet wird. Wird die Schicht mit ausreichender Intensität schnell unter

1s belichtet, so ist die Schicht weniger trüb, als wenn mit schwächeren Leistungen längere Zeit mehrere Sekunden lang belichtet wird. Die Trübheit (engl. Haze) ist messbar und wird als Haze-Wert in Prozent angegeben. Die Differenz zwischen den schnell und langsam belichteten Gebieten sollte bei einer Belichtungstemperatur von 21°C und einer Schichtdicke von 1mm, gemessen nach dem ASTM D Standardverfahren, mindestens 50%, bevorzugt mindestens 60% und besonders bevorzugt mindestens 70% erreichen. Auch die Temperatur hat einen Einfluss auf die Trübheit. Je niedriger die Temperatur ist, desto milchiger wird das Ergebnis. Die Belichtung verschiedener Bereiche bei unterschiedlichen Temperaturen kann somit ebenfalls einen Unterschied bewirken oder den intensitätsabhängigen Effekt noch verstärken.

Die Empfindlichkeit der photopolymerisierbaren Zusammensetzung sollte besser als 100mJ/cm$^2$, bevorzugt besser als 50mJ/cm$^2$ und besonders bevorzugt besser als 30mJ/cm$^2$ sein.

Vorzugsweise wird bei der erfindungsgemäßen Zusammensetzung kein Lösungsmittel und auch keine thermische Nachbehandlung benötigt. Es kann sofort nach dem Auftragen der Zusammensetzung auf ein Substrat belichtet werden. Der Nassauftrag der Zusammensetzung auf das Trägermaterial kann durch Rakeln, Doctor Blade oder Schlitzdüsen (Slot-Dye Coating) erfolgen. Für dünne Schichten kleiner 20$\mu$m können auch bekannte Druckverfahren, wie Sieb-, Tief-, Gravur-, Tampon- oder Flexodruck verwendet werden. Bevorzugt wird die photopolymerisierbare Zusammensetzung mit einer transparenten und klaren Folie direkt auf die zu kopierende Vorlage (Master) laminiert. Die Schichtdicke wird entweder durch den Anpressdruck und der Laminiergeschwindigkeit oder über die Schlitzbreite eingestellt. Bei der Beschichtung von dicken und starren Trägern wie z.B. Glasplatten kann ein Spin Coating Verfahren verwendet werden. Auch das Auftragen mit einem Tintenstrahldruckverfahren oder mit einer CNC gesteuerten Dosiervorrichtungen ist möglich. Das direkte Einspritzen in Hohlräumen ist ebenfalls möglich.

Insbesondere eignet sich die photopolymerisierbare Zusammensetzung auch für den Auftrag auf gekrümmten Oberflächen. Es kann auch zwischen zwei zueinander passenden Körpern eingepresst und gleichzeitig als Kit oder Kleber verwendet werden.

Der Anwender hat außerdem die freie Wahl, welche Trägermaterialien und Schichtaufbauten er verwenden möchte, da die Beschichtung in der Belichtungsanlage erfolgt. Das lösemittelfreie Material kann sofort nach dem Auftrag belichtet werden. Mehrschichtige Belichtungen sind ebenfalls kein Problem, da nach der Härtung nach den selben Prinzip eine neue Schicht aufgetragen und holographisch belichtet werden kann.Dies kann z.B. dazu genutzt werden, um echtfarbige Hologramme aus drei Schichten für die Grundfarben Rot, Grün und Blau aufzubauen.

Die Verwendung von Triglyceriden bzw. modifizierten Triglyceriden bei der Herstellung von photopolymerisierbaren Zusammensetzungen als holographische Aufzeichnungsmaterialien hat darüber hinaus weitere wesentliche Vorteile: Das belichtete Photopolymer weist eine verringerte Oberflächenhaftung auf, da das Triglycerid bzw. das modifizierte Triglycerid gleichzeitig als Trennmittel fungiert. Das belichtete Hologramm kann daher leicht und restlos von einem Substrat, wie z.B. Glas, entfernt werden. Auch diese Eigenschaft ist für die Massenproduktion sehr günstig, weil somit verschleißfrei Kopiermaster, wie herkömmliche Nickelshims mit einer feinen holographischen Oberflächenstruktur oder mit Dünnglas versiegelte Volumenhologramme, für die Anfertigung von Kontaktkopien verwendet werden können. Durch die restlose Entfernung der nicht klebrigen Schicht bleibt der Reinigungsaufwand gering.

Die photopolymerisierbare Zusammensetzung ist besonders für die Anfertigung von Kontaktkopien geeignet. Dadurch, dass die flüssige photopolymerisierbare Zusammensetzung direkt auf das Master aufgedruckt wird, entfällt das Indexmatching. Darunter wird das Auftragen einer Flüssigkeit zwischen Master und Hologrammschicht mit ungefähr dem gleichen Brechungsindex der beiden Schichten verstanden. Das Indexmatching verhindert beim normalen Kontaktkopierverfahren mit Filmmaterialien das Auftreten von störenden Interferenzerscheinungen (Newtonringe). Diese entstehen durch Reflexionen, die besonders an den Stellen auftreten, wo sich die beiden Schichten z.B. wegen eines Staubeinschlusses oder einer kleinen Unebenheit nicht direkt berühren und es zu Blasen bzw. Lufteinschlüssen.kommt. Zudem verbessert der Ausgleich von Kratzern und anderen Unebenheiten vom Trägermaterial und Master die optische Qualität der Kopie. Kleine Staubteilchen mit einer geringeren Abmessung als die Schichtdicke werden in der Flüssigkeit eingebettet und erzeugen keine deutlichen Druck- und Fehlstellen wie bei den Filmmaterialien. Dies verringert den Ausschuss und die Reinraumansprüche an die Produktionsumgebung wesentlich.

Vorteilhaft kann die flüssige photopolymerisierbare Zusammensetzung somit auch als Indexmatch-Material für die Belichtung von holographischen Filmmaterialien eingesetzt werden. Dadurch, dass es beim Belichten aushärtet, entfällt die Reinigung oder das Abdampfen. Zudem wird die holographische Aufzeichnung durch die Kombination der beiden holographischen Aufzeichnungsmaterialien unterstützt und verstärkt, da in beiden Schichten ein Hologramm entsteht.

Weil sich die photopolymerisierbare Zusammensetzung jeder Oberfläche anpasst, können im Gegensatz zu den Filmmaterialien neben der Hologrammbelichtung gleichzeitig auch Oberflächenstrukturen abgeformt und komplex geformte Oberflächen verwendet werden. Die Oberflächenstrukturen können insbesondere Prägehologramme oder Fresnelstrukturen sein. Dadurch ist es möglich, in einem einzelnen Verarbeitungsschritt sowohl die Oberflächenstruktur als auch die volumenholographische oder optische Information des Masters physikalisch und holographisch zu kopieren.

Auf dieser Weise lassen sich auch optische Elemente wie Prismen oder Linsen mit integrierten Hologrammstrukturen herstellen.

Dadurch, dass die photopolymerisierbare Zusammensetzung nach dem Auftragen sofort belichtet werden kann, sind kompakte Beschichtungs- und Belichtungszeiten mit sehr kurzen Transportwegen und Zeiten zwischen diesen zwei Stationen realisierbar. Somit sinkt die Gefahr einer ungewollten Vorbelichten durch Umgebungslicht. Die Anforderung an einer dunklen Umgebung sind daher nicht groß. Die photopolymerisierbare Zusammensetzung kann innerhalb von 1min, bevorzugt innerhalb von 20s, besonders bevorzugt innerhalb von 5s aufgetragen und belichtet werden.

Die erfindungsgemäße photopolymerisierbare Zusammensetzung umfasst eine erste Mischung A, umfassend mindestens ein Monomer M, umfassend mindestens eine ethylenisch ungesättigte Gruppe, vorzugsweise ein Monomer M, umfassend mindestens zwei ethylenisch ungesättigte Gruppen.

Besonders bevorzugt umfasst die photopolymerisierbare Zusammensetzung eine erste Mischung A, umfassend mindestens ein Monomer M, umfassend mindestens eine ethylenisch ungesättigte Gruppe, und ein Monomer M1, umfassend mindestens zwei ethylenisch ungesättigte Gruppen, wobei sich M1 vorzugsweise von M nur durch die zweite ethylenisch ungesättigte Gruppe unterscheidet.

Dabei kann das Monomer, umfassend mindestens eine ethylenisch ungesättigte Gruppe, nachfolgende allgemeine Struktureinheiten aufweisen.

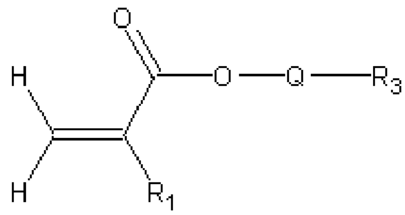

Acrylate

**oder**

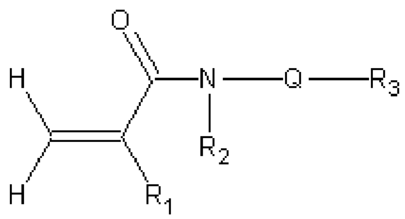

Acrylamide

**oder**

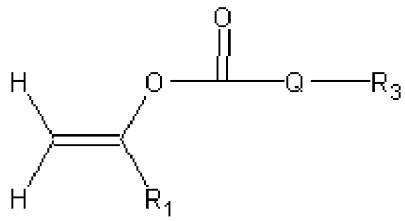

Vinylester

**oder**

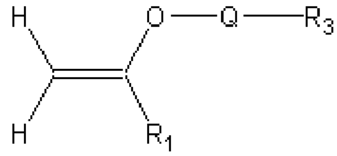

Vinylether

**oder**

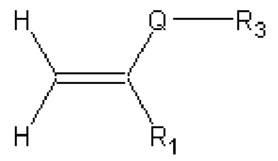

vinylische

**oder**

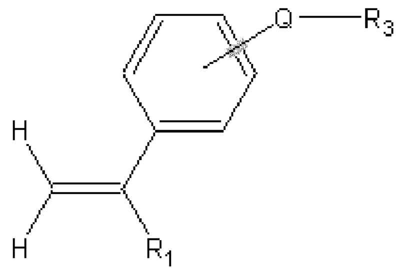

Styrole

wobei

$$Q= -\left(CH_2\right)_q-\left(O\right)_o- \text{ oder } -\left(CH_2\right)_q-Ar-\left(CH_2\right)_p-\left(O\right)_o-$$

wobei q, p = 0-12, vorzugsweise 1-12; o = 0, 1; und Ar ein ein- oder mehrkerniger substituierter oder unsubstituierter aromatischer oder heterocyclischer aromatischer Rest ist,

wobei der Rest $R_1$ H, Methyl oder Ethyl ist und

wobei die Reste $R_2$ und $R_3$ unabhängig voneinander ausgewählt sind aus der Gruppe bestehend aus Alkyl-, Alkenyl-, Alkinyl-, Alkoxy-, Acyl- und Acyloxyresten, die gerad- oder verzweigtkettig, unsubstituiert oder substituiert sein können, substituierte oder unsubstituierte Aryloxyreste, substituierte oder unsubstituierte aromatische Reste oder heterocyclische Reste, unsubstituierte oder substituierte alicyclische Kohlenwasserstoffreste, aliphatische, aromatische und aliphatischaromatische Amino-, Carbonsäure-, Amido- und Imidoreste, Hydroxy, Amino, Cyano, Nitro, Halogenatome oder Wasserstoffatome und Kombinationen der vorstehend genannten Reste, wobei die substituierten Reste substituiert sein können mit $C_1$-$C_{12}$ Alkyl-, $C_1$-$C_{12}$ Alkoxy-, Hydroxy-, Carboxy-, Carbonyl-, Amino-, Amido-, Imidoresten, Halogenatomen, aromatischen Resten oder Kombinationen davon.

Beispiele für geeignete Monomere M sind substituierte oder unsubstituierte Styrolmonomere, Acrylsäure, α-Alkylacrylsäure, Acrylsäureester, α-Alkylacrylsäureester, deren Alkoholkomponente ein substituierter oder unsubstituierter aliphatischer oder aromatischer Rest mit 2-50 Kohlenstoffatomen sein kann, Acrylamide, α-Alkylacrylamide, wobei Alkyl die vorstehend angegebene Bedeutung hat, Vinylester, Vinylalkohol, Vinylether und sonstige substituierte vinylische Monomere, substituiert mit substituierten oder unsubstituierten aliphatischen oder aromatischen Resten mit 2-50 Kohlenstoffatomen.

Bevorzugte Beispiele für geeignete Monomere M sind (Meth)acrylsäurebutylester, (Meth)acrylsäurephenylester, (Meth)acrylsäurebenzylester, (Meth)acrylsäureisobornylester, (Meth)acrylsäurecyclohexylester, (Meth)acrylsäure-2-phenoxyethylester, (Meth)acrylsäure-1H, 1H,2H,2H-perfluoroctylester, 2,2,2-Trifluorethyl(meth)acrylat, Heptafluorpropyl(meth)acrylat, 1,1,1,3,3,3-Hexyfluorisopropyl(meth)acrylat, 2,2,3,3-Tetrafluorpropyl(meth)acrylat), 2,2,3,3,4,4,4-Heptafluorbutyl(meth)acrylat, 2,2,3,3,4,4,5,5-Octafluorpentyl(meth)acrylat, AcrylsäureN,N-diethylaminoethylester, Acrylsäureethoxyethyoxyethylester, Acrylsäure-2-(p-chlorphenoxy)ethylester, p-Chlorphenylacrylat, 2-Phenylethyl(meth)acrylat, Pentachlorphenylacrylat, Phenylacrylat, p-Chlorstyrol, n-Vinylcarbazol, 1-Vinyl-2-pyrolidon, 2-Chlorstyrol, 2-Bromstyrol, Methoxystyrol, Phenolethoxylatacrylat, 2-(p-Chlorphenoxy)-ethylacrylat, 2-(1-Naphthyloxy)ethylacrylat, Hydrochinonmonomethacrylat und 2-[β-(N-Carbazolyl)propionyloxy]ethylacrylat.

Besonders bevorzugte Monomere M sind N-Vinylcarbazol, Ethoxyethoxyethylacrylat, 2-Naphthylacrylat, 2-Phenoxyethylacrylat, 2-Phenoxyethylmethacrylat, Phenolethoxylatacrylat, 2-(p-Chlorphenoxy)ethylacrylat, p-Chlorphenylacrylat, Phenylacrylat, 2-Phenylethylacrylat, 2-(1-Naphthyloxy)ethylacrylat, t-Butylacrylat, Isobornylacrylat, Cyclohexylacrylat, N,N-Diethylaminoethylacrylat, Acrylamid, Ethoxyethoxyethylacrylat, 1H, 1H,2H,2H-Perfluoroctylmethacrylat

und Pentafluorethylacrylat.

Vorzugsweise umfasst das Monomer M mindestens zwei ethylenisch ungesättigte Gruppen, daher ist das Monomer bevorzugt difunktionell.

Difunktionelle ethylenisch ungesättigte Monomere weisen zwei C-C-Doppelbindungen im Molekül auf, d.h. sie enthalten z.B. zwei der voranstehend angegebenen Struktureinheiten. Ein difuntionlles ethylenisch ungesättigtes Monomer kann z.B. zwei Acrylat- oder Methacrylatgruppen enthalten.

Das Monomer M in der erfindungsgemäßen photopolymerisierbaren Zusammensetzung kann ausschließlich aus einem oder mehreren difunktionellen oder höher funktionellen Monomer bestehen, d.h. die Zusammensetzung kann frei von monofunktionellen ethylenisch ungesättigten Monomeren sein. Der Gehalt an Monomeren M mit mindestens zwei ethylenisch ungesättigten Gruppen in der erfindungsgemäßen Zusammensetzung beträgt mehr als 5 Gew.%, bevorzugt mehr als 10 Gew.%, und besonders bevorzugt mehr als 20 Gew.%.

Die Verwendung von difunktionellen oder höher funktionellen Monomeren führt insbesondere zu einer besonders hohen thermischen und mechanischen Stabilität der hergestellten holographischen Elemente und ist insbesondere bei der Herstellung von Refexionshologrammen vorteilhaft.

Bevorzugte Monomere M mit mindestens zwei ethylenisch ungesättigten Gruppen sind ethoxylierte Bisphenol-A-Diacrylate, insbesondere Verbindungen der folgenden Formel

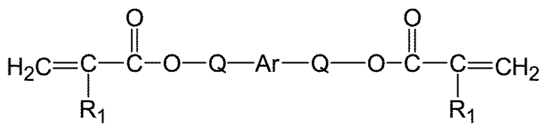

worin $R_1$, Q und Ar die oben angegebene Bedeutung haben.

Ein besonders bevorzugtes Monomer M ist die Verbindung der folgenden Strukturformel:

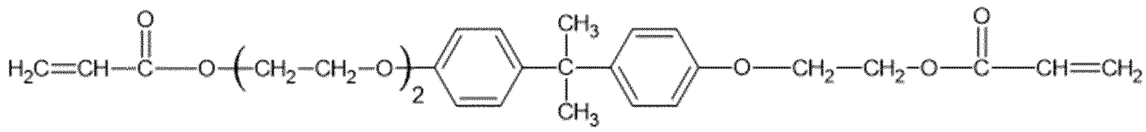

Bevorzugt beträgt die Viskosität des Monomers M bzw. Monomergemisches bei Raumtemperatur mindestens 900 mPa·s.

Die Viskosität der photopolymerisierbaren Zusammensetzung beträgt ebenfalls bei 20°C mindestens 900mPa s, bevorzugt 1500mPa s und besonders bevorzugt mindestens 2000mPa s.

Die erfindungsgemäße photopolymerisierbare Zusammensetzung umfasst eine erste Mischung A, umfassend ein Triglycerid und/oder ein modifiziertes Triglycerid.

Die geeigneten Triglyceride sind allgemein Verbindungen der folgenden allgemeinen Strukturformel

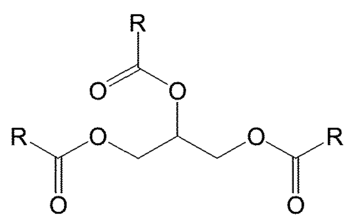

worin die R, jeweils unabhängig voneinander, für einen Fettsäurerest stehen; bevorzugt enthält R jeweils 6 bis 22, mehr bevorzugt 8 bis 18, Kohlenstoffatome.

Als Triglycerid können auch natürlich vorkommende Öle oder Fette wie z.B. Rizinusöl, Kokosöl, Palmkernöl und Gemische davon eingesetzt werden. Auch Derivate (z.B. Hydrierungsprodukte) solcher natürlichen Fette und Öle können eingesetzt werden. Solche natürlich vorkommenden Öle oder Fette sind bzw. enthalten im allgemeinen Gemische verschiedener Triglyceride.

Ein besonders bevorzugtes Triglycerid ist das Triglycerid der Ricinolsäure, das ein Hauptbestandteil des Rizinusöls ist.

Bevorzugt wird das Triglycerid so gewählt, dass der Betrag der Differenz zwischen dem Brechungsindex (n) des ethylenisch ungesättigten Monomers oder Monomergemisches und dem Brechungsindex des Triglycerids (d.h. |n(Monomer) - n(Triglycerid)|) bei 20°C mindestens 0,02, mehr bevorzugt mindestens 0,05, am meisten bevorzugt

mindestens 0,07 beträgt.

Als modifiziertes Triglycerid kommen beispielsweise ethyoxylierte Rizinusöle bzw. deren Ricinolsäuren in Betracht. Vorzugsweise umfasst das modifizierte Triglycerid ethoxylierte Triglyceride mit 25 bis 250 Einheiten basierend auf Etylenoxid. Beispielsweise kann Hedipin R/2000 auch als "PEG-200 castoir oil" bekannt) verwendet werden.

Hedipin R/2000 wird hergestellt, indem Rizinusöl mit Ethylenoxid in einem molaren Verhältnis von 1:200 umgesetzt wird. Rizinusöl ist eine Mischung aus Triglyceriden, das aus den Samen von *Ricinus communis* gewonnen wird. Der Hauptbestandteil von Rizinusöl (>80%) ist das Triglycerid der Ricinolsäure. Hedipin R/2000 enthält eine Mischung polyethoxylierter Triglyceride, wobei die polyethoxlierten Produkte des Triglycerids der Ricinolsäure den Hauptbestandteil bilden. Die polyethoxlierten Produkte des Triglycerids der Ricinolsäure umfassen eine oder mehrere der Verbindungen der Formel A, B und C und Mischungen davon, sowie alle Stereoisomere davon. Als weitere Bestandteile kann Hedipin R/2000 Polyoxyethylenricinoleate, freie Polyethylenglycole und ethoxylierte Glycerine umfassen.

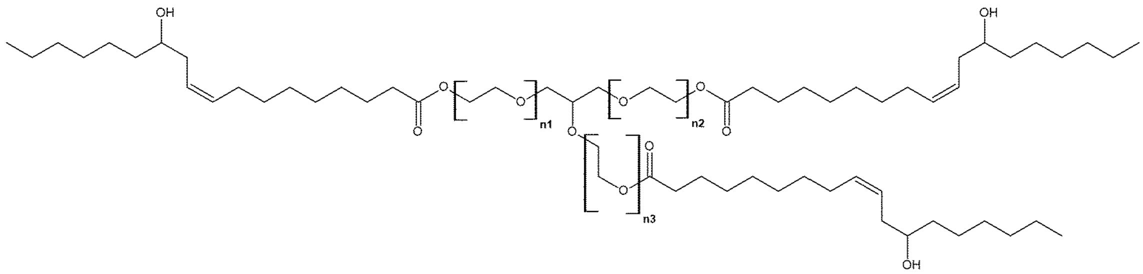

Formel (A)

In der Formel (A) sind n1, n2 und n3 unabhängig voneinander eine ganze Zahl von 0-200, bevorzugter von 10-180, bevorzugter von 20-150, bevorzugter von 30-130, bevorzugter von 40-110, bevorzugter von 50-90, bevorzugter von 60-75, wobei n1+n2+n3 = 150-250.

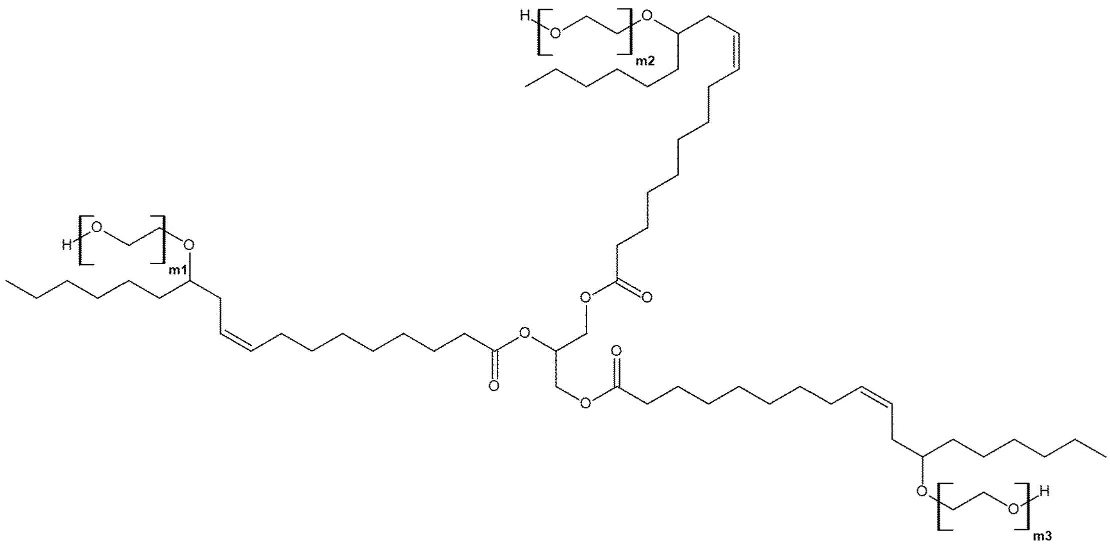

Formel (B)

In der Formel (B) sind m1, m2 und m3 unabhängig voneinander eine ganze Zahl von 0-200, bevorzugter von 10-180, bevorzugter von 20-150, bevorzugter von 30-130, bevorzugter von 40-110, bevorzugter von 50-90, bevorzugter von 60-75, wobei m1+m2+m3 = 150-250.

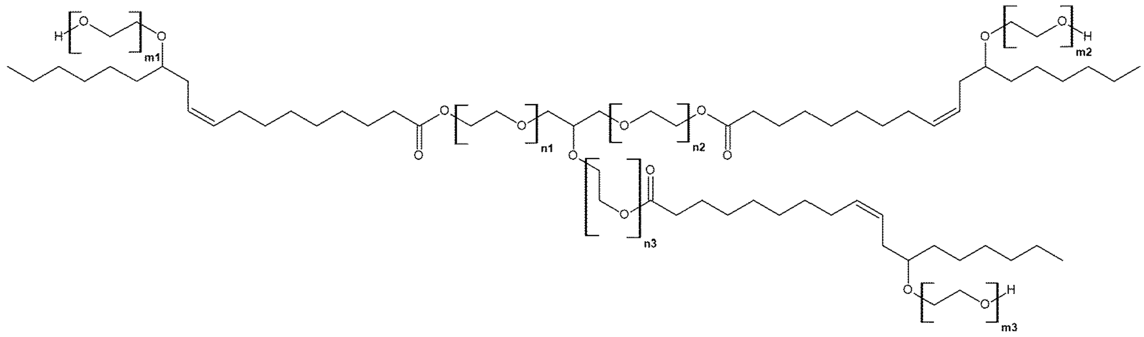

Formel (C)

In der Formel (C) sind n1, n2 und n3 jeweils unabhängig voneinander eine ganze Zahl von 0-200, bevorzugter von 5-175, bevorzugter von 10-150, bevorzugter von 15-125, bevorzugter von 20-100, bevorzugter von 20-75, bevorzugter von 25-40, wobei n1+n2+n3 = 50-150.

In der Formel (C) sind m1, m2 und m3 jeweils unabhängig voneinander eine ganze Zahl von 0-200, bevorzugter von 5-175, bevorzugter von 10-150, bevorzugter von 15-125, bevorzugter von 20-100, bevorzugter von 20-75, bevorzugter von 25-40, n1+n2+n3 = 50-150.

Bevorzugt sind in der Formel (C) n1, n2, n3, m1, m2 und m3 jeweils unabhängig voneinander eine ganze Zahl von 10-150, bevorzugter von 15-125, bevorzugter von 20-100, bevorzugter von 20-75, bevorzugter von 25-40, wobei n1+n2+n3+m1+m2+m3 = 150-250.

Die erfindungsgemäße photopolymerisierbare Zusammensetzung umfasst eine erste Mischung A, umfassend mindestens einen Photoinitiator, der vorzugsweise die Polymerisation des oder der Monomeren M bei der Einwirkung (aktinischer) Strahlung aktiviert. Dabei handelt es sich vorzugsweise um einen radikalbildenden Polymerisationsinitiator.

Radikalbildende Polymerisationsintitiatoren sind bekannt, vgl. z.B. Timpe, H.J. und S. Neuenfeld, "Dyes in photoinitiator systems", Kontakte (1990), Seiten 28-35 und Jakubiak, J. und J.F. Rabek, "Photoinitiators for visible light polymisation", Polimery (Warschau) (1999), 44, Seiten 447-461.

Zu den geeigneten radikalbildenden Polymerisationsinitiatoren, die durch UV-Strahlung aktivierbar und im allgemeinen bei Temperaturen bis zu 185°C inaktiv sind, gehören die substituierten oder unsubstituierten mehrkernigen Chinone; dabei handelt es sich um Verbindungen mit zwei intracyclischen Kohlenstoff-Atomen in einem konjugierten carbocyclischen Ringsystem, z.B. 9,10-Anthrachinon, 1-Chloranthrachinon, 2-Chloranthrachinon, 2-Methylanthrachinon, 2-Ethylanthrachinon, 2-tert-Butylanthrachinon, Octamethylanthrachinon, 1,4-Naphthochinon, 9,10-Phenanthrenchinon, 1,2-Benzanthrachinon, 2,3-Benzanthrachinon, 2-Methyl-1,4-naphthochinon, 2,3-Dichlornaphthochinon, 1,4-Dimethylanthrachinon, 2,3-Dimethylanthrachinon, 2-Phenylanthrachinon, 2,3-Diphenylanthrachinon, Natrium-Salz von Anthrachinon-α-sulfonsäure, 3-Chlor-2-methylanthrachinon, Retenchinon, 7,8,9,10-Tetrahydronaphthacenchinon und 1,2,3,4-Tetrahydrobenz[a]anthracen-7,12-dion. Weitere Photoinitiatoren, die ebenfalls brauchbar sind, wenn auch manche bei so niedrigen Temperaturen wie 85°C thermisch aktiv sind, sind in US-Patent 2 760 663 A beschrieben, und zu ihnen zählen vicinale Ketaldonylalkohole wie etwa Benzoin, Pivaloin, Acyloinether, z.B. Benzoinmethyl- und -ethylether, α-Kohlenwasserstoff-substituierte aromatische Acyloine, darunter α-Methylbenzoin, α-Allylbenzoin und α-Phenylbenzoin.

Als Photoinitiator verwendbar sind photoreduzierbare Farbstoffe und Reduktionsmittel wie etwa die in den US-Patenten 2 850 445 A, 2 875 047 A, 3 097 096 A, 3 074 974, 3 097 097 A, und 3 579 339 A offenbarten, sowie Farbstoffe aus der Klasse der Phenazine, Oxazine und Chinone; Michlers Keton, Benzophenon, 2,4,5-Triphenylimidazolyl-Dimere mit Wasserstoff-Donoren und deren Mischungen, wie beschrieben in den US-Patenten 3 427 161 A, 3 479 185 A, 3 549 367 A, 4 311 783 A, 4 622 286 A und 3 784 557 A. Eine brauchbare Diskussion der farbstoffsensibilisierten Photopolymerisation findet sich in "Dye Sensitized Photopolymerization" von D.F: Eaton in Adv. in Photochemistry, Bd. 13, D.H. Volman, G.S. Hammond und K. Gollnick, Hrsg., Wiley-Interscience, New York, 1986, S. 427-487. In gleicher Weise sind auch die Cyclohexadienon-Verbindungen von US-Patent Nr. 4 341 860 als Initiatoren brauchbar. Zu den geeigneten Photoinitiatoren gehören CDM-HABI, d.h., 2-(o-Chlorphenyl)-4,5-bis(m-methoxyphenyl)-imidazol-Dimer; o-Cl-HABI, d.h., 2,2'-Bis(o-chlorphenyl)-4,4',5,5'-tetraphenyl-1,1'-biimidazol; und TCTM-HABI, d.h., 2,5-Bis(o-chlorphenyl)-4-(3,4-dimethoxyphenyl)-1H-imidazol-Dimer, die jeweils typischerweise mit einem Wasserstoff-Donor verwendet werden, z.B. 2-Mercaptobenzoxazol.

Besonders bevorzugte UV-Photoinitiatoren sind IRGACURE® OXE-01 (1,2-Octandion-1-[4-(phenylthio)-phenyl]-2-(O-benzoyloxim) und IRGACURE® OXE-02 (1-[9-Ethyl-6-(2-methylbenzoyl)-9H-carbazol-3-yl]ethanon-O-acetyloxim von der der BASF AG, sowie OMNIRAD-MBF (Methylbenzoylformiat), OMNIRAD-TPO (2,4,6-Trimethylbenzoyl-diphenyl-phosphinoxid), OMNIRAD-TPO-L (Ethyl-(2,4,6-trimethylbenzoyl)-phenylphosphinat), OMNIRAD-1173 (2-Hydroxy-2-methyl-1-phenylpropanon), OMNIRAD 1000 (Mischung aus 2-Hydroxy-2-methyl-1-phenylpropanon (80%) und 1- Hydroxycyclohexyl-phenylketon (20%)), OMNIRAD 184 (1-Hydroxycyclohexyl-phenylketon), OMNIRAD 819 (Bis(2,4,6-trimethylbenzoyl)phenylphosphinoxid), OMNIRAD 2022 (Mischung aus 2-Hydroxy-2-methyl-1-phenylpropanon, Bis(2,4,6-trimethylbenzoyl)phenylphosphinoxid und Ethyl(2,4,6-trimethylbenzoyl)-phenylphosphinat) und OMNICAT 440 (4,4'-Dimethyl-diphenyl-iodonium-hexafluorphosphat), die von IGM Resins erhältlich sind und bevorzugt in einer Menge von 0,1 bis 10 Gew.% eingesetzt werden.

| | | |
|---|---|---|
| 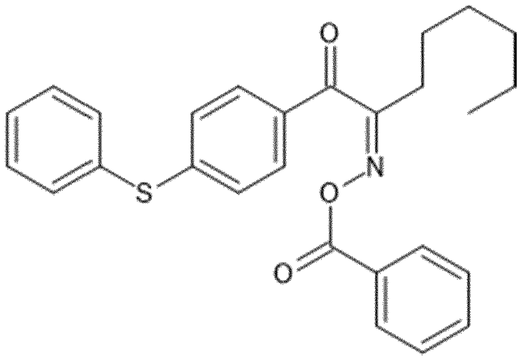 | | 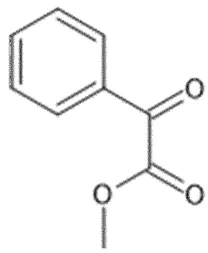 |
| **IRCACURE® OXE-01** | | **OMNIRAD MBF** |
| 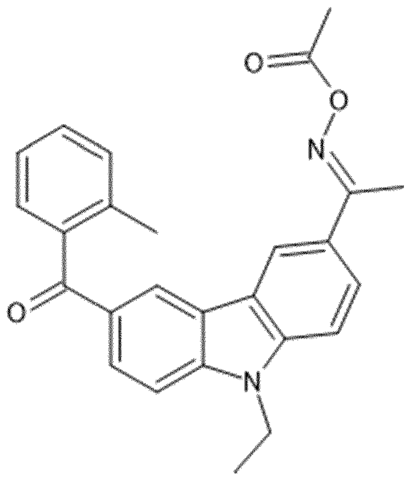 | 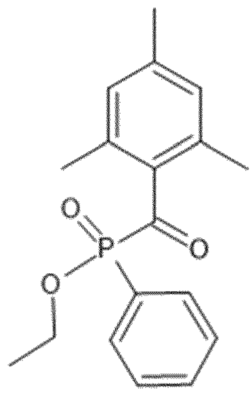 | 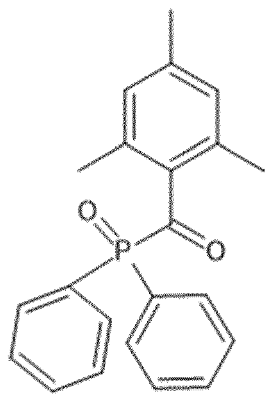 |
| **IRGACURE® OXE-02** | **OMNIRAD TPO-L** | **OMNIRAD TPO** |
| 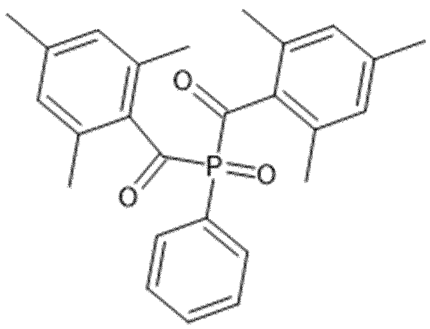 | 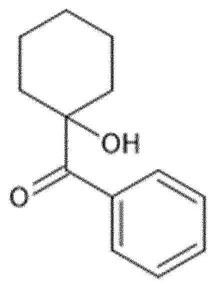 | 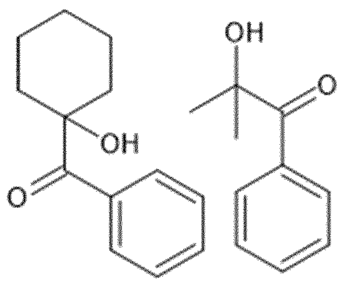 |
| **OMNIRAD 819** | **OMNIRAD 184** | **OMNIRAD 1000** |

(fortgesetzt)

| | | |
|---|---|---|
| 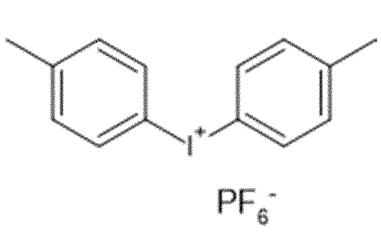 | 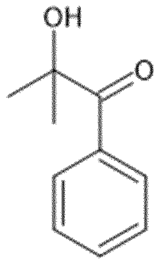 | |
| **OMNICAT 440** | **OMNIRAD 1173** | |
| 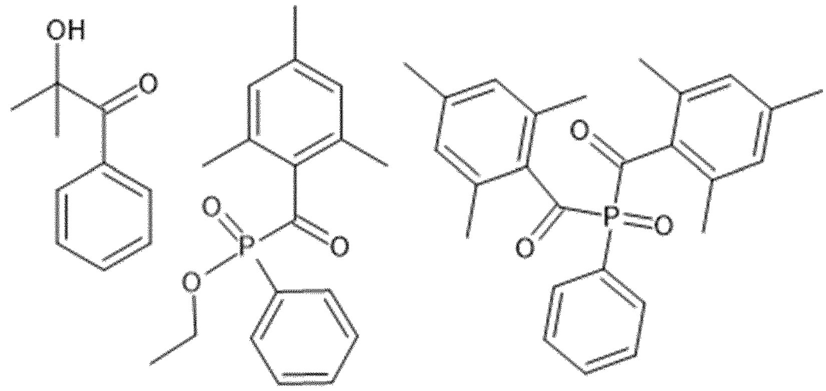 | | |
| **OMNIRAD 2022** | | |

Die voranstehend genannten Photoinitiatoren können alleine oder in Kombination eingesetzt werden.

Ein besonders bevorzugter Photoinitiator umfasst die Verbindung der folgenden Strukturformel I (Co-Photoinitiator) und Farbstoffe (Sensibilisierungsmittel), wie z.B. Methylenblau, und die in den US-Patenten 3 554 753 A, 3 563 750 A, 3 563 751 A, 3 647 467 A, 3 652 275 A, 4 162 162 A, 4 268 667 A, 4 454 218 A, 4 535 052 A und 4 565 769 A offenbarten Sensibilisierungsmittel, sowie die in der Anmeldung WO 2012062655 A2 genannten Farbstoffe und Co-Photoinitiatoren, auf die hierin ausdrücklich Bezug genommen wird. Zu den besonders bevorzugten Sensibilisierungsmitteln gehören die folgenden: DBC, d.h., 2,5-Bis[(4-diethyl-amino-2-methylphenyl)methylen]cyclopentanon; DEAW, d.h., 2,5-Bis[(4-diethylaminophenyl)methylen]cyclopentanon; Dimethoxy-JDI, d.h., 2,3-Dihydro-5,6-dimethoxy-2-[(2,3,6,7-tetrahydro-1H,5H-benzo[i,j]chinolizin-9-yl)methylen]-1H-inden-1-on; und Safranin O, d.h., 3,7-Diamino-2,8-dimethyl-5-phenyl-phenaziniumchlorid.

Die Verbindung mit der Strukturformel I, die unter der Bezeichnung "CGI 7460" von Ciba Specialty Chemicals Inc. entwickelt wurde und nun unter dem Namen SEC LCA 1460 bei der BASF AG erhältlich ist, wird wie folgt dargestellt:

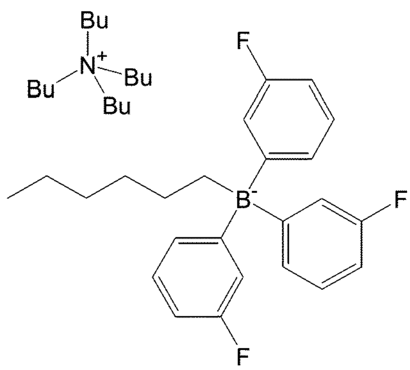

(I)

Besonders bevorzugt können die Farbstoffe als Farbstoffkonzentrate (siehe Tabelle 4) in einer Mischung ohne flüchtige Lösungsmittel zur Verfügung gestellt werden. Dies vereinfacht die Zubereitung der photopolymerisierbaren Zusammensetzungen, da auf ein Auskochen der flüchtigen Substanzen verzichtet und auch einfacher und genauer dosiert werden

kann.

Vorzugsweise ist der Farbstoff in den erfindungsgemäßen photopolymerisierbaren Zusammensetzungen ausgewählt aus der Gruppe, bestehend aus Acriflavinen, Diaminoacridinen, Rhodamin B, Safranin-O, Diethylsafranin und Methylenblau.

Vorzugsweise ist der Co-Photoinitiator in dem erfindungsgemäßen photopolymerisierbaren Zusammensetzungen ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

Ganz besonders bevorzugt ist der Farbstoff in den erfindungsgemäßen photopolymerisierbaren Zusammensetzungen ausgewählt aus der Gruppe, bestehend aus Acriflavinen, Diaminoacridinen, Rhodamin B, Safranin-O, Diethylsafranin und Methylenblau, und wird mit einem Co-Photoinitiator kombiniert ausgewählt aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat oder Mischungen daraus.

In der erfindungsgemäßen Zusammensetzung umfasst die erste Mischung A zudem mindestens einen aromatischen Aldehyd und/oder aliphatischen Aldehyd.

Vorzugsweise ist der aromatische Aldehyd ausgewählt aus der Gruppe, bestehend aus Vanillin, Coniferylaldehyd, 2-Methoxybenzaldehyd, 3-Methoxybenzaldehyd, 4-Methoxybenzaldehyd, 2-Ethoxybenzaldehyd, 3-Ethoxybenzaldehyd, 4-Ethoxybenzaldehyd, 4-Hydroxy-2,3-dimethoxy-benzaldehyd, 4-Hydroxy-2,5-dimethoxy-benzaldehyd, 4-Hydroxy-2,6-dimethoxy-benzaldehyd, 4-Hydroxy-2-methyl-benzaldehyd, 4-Hydroxy-3-methyl-benzaldehyd, 4-Hydroxy-2,3-dimethyl-benzaldehyd, 4-Hydroxy-2,5-dimethyl-benzaldehyd, 4-Hydroxy-2,6-dimethyl-benzaldehyd, 4-Hydroxy-3,5-dimethoxy-benzaldehyd, 4-Hydroxy-3,5-dimethyl-benzaldehyd, 3,5-Diethoxy-4-hydroxy-benzaldehyd, 2,6-Diethoxy-4-hydroxybenzaldehyd, 3-Hydroxy-4-methoxy-benzaldehyd, 2-Hydroxy-4-methoxy-benzaldehyd, 2-Ethoxy-4-hydroxybenzaldehyd, 3-Ethoxy-4-hydroxy-benzaldehyd, 4-Ethoxy-2-hydroxy-benzaldehyd, 4-Ethoxy-3-hydroxy-benzaldehyd, 2,3-Dimethoxybenzaldehyd, 2,4-Dimethoxybenzaldehyd, 2,5-Dimethoxybenzaldehyd, 2,6-Dimethoxybenzaldehyd, 3,4-Dimethoxybenzaldehyd, 3,5-Dimethoxybenzaldehyd, 2,3,4-Trimethoxybenzaldehyd, 2,3,5-Trimethoxybenzaldehyd, 2,3,6-Trimethoxybenzaldehyd, 2,4,6-Trimethoxybenzaldehyd, 2,4,5-Trimethoxybenzaldehyd, 2,5,6-Trimethoxybenzaldehyd, 2-Hydroxybenzaldehyd, 3-Hydroxybenzaldehyd, 4-Hydroxybenzaldehyd, 2,3-Dihydroxybenzaldehyd, 2,4-Dihydroxybenzaldehyd, 2,4-Dihydroxy-3-methyl-benzaldehyd, 2,4-Dihydroxy-5-methyl-benzaldehyd, 2,4-Dihydroxy-6-methyl-benzaldehyd, 2,4-Dihydroxy-3-methoxy-benzaldehyd, 2,4-Dihydroxy-5-methoxy-benzaldehyd, 2,4-Dihydroxy-6-methoxy-benzaldehyd, 2,5-Dihydroxybenzaldehyd, 2,6-Dihydroxybenzaldehyd, 3,4-Dihydroxybenzaldehyd, 3,4-Dihydroxy-2-methyl-benzaldehyd, 3,4-Dihydroxy-5-methyl-benzaldehyd, 3,4-Dihydroxy-6-methyl-benzaldehyd, 3,4-Dihydroxy-2-methoxybenzaldehyd, 3,4-Dihydroxy-5-methoxy-benzaldehyd, 3,5-Dihydroxybenzaldehyd, 2,3,4-Trihydroxybenzaldehyd, 2,3,5-Trihydroxybenzaldehyd, 2,3,6-Trihydroxybenzaldehyd, 2,4,6-Trihydroxybenzaldehyd, 2,4,5-Trihydroxybenzaldehyd, 3,4,5-Trihydroxybenzaldehyd, 2,5,6-Trihydroxybenzaldehyd, 4-Hydroxy-2-methoxybenzaldehyd, 4-Dimethylaminobenzaldehyd, 4-Diethylaminobenzaldehyd, 4-Dimethylamino-2-hydroxybenzaldehyd, 4-Diethylamino-2-hydroxybenzaldehyd, 4-Pyrrolidinobenzaldehyd, 4-Morpholinobenzaldehyd, 2-Morpholinobenzaldehyd, 4-Piperidinobenzaldehyd, 2-Methoxy-1-naphthaldehyd, 4-Methoxy-1-naphthaldehyd, 2-Hydroxy-1-naphthaldehyd, 2,4-Dihydroxy-1-napthaldehyd, 4-Hydroxy-3-methoxy-1-naphthaldehyd, 2-Hydroxy-4-methoxy-1-naphthaldehyd, 3-Hydroxy-4-methoxy-1-naphthaldehyd, 2,4-Dimethoxy-1-naphthaldehyd, 3,4-Dimethoxy-1-naphthaldehyd, 4-Hydroxy-1-naphthaldehyd, 4-Dimethylamino-1-naphthaldehyd, 4-Dimethylaminozimtaldehyd, 2-Dimethylaminobenzaldehyd, 2-Chlor-4-dimethylaminobenzaldehyd, 4-Dimethylamino-2-methylbenzaldehyd, 4-Diethylamino-zimtaldehyd, 4-Dibutylamino-benzaldehyd, 4-Diphenylamino-benzaldehyd, 4-Dimethylamino-2-methoxybenzaldehyd, 4-(1-Imidazolyl)-benzaldehyd, Piperonal, 2,3,6,7-Tetrahydro-1H,5H-benzo[ij]chinolizin-9-carboxaldehyd, 2,3,6,7-Tetrahydro-8-hydroxy-1H,5H-benzo[ij]chinolizin-9-carboxaldehyd, N-Ethylcarbazol-3-aldehyd, 2-Formylmethylen-1,3,3-trimethylindolin (Fischers Aldehyd oder Tribasen Aldehyd), 2-Indolaldehyd, 3-Indolaldehyd, 1-Methylindol-3-aldehyd, 2-Methylindol-3-aldehyd, 1-Acetylindol-3-aldehyd, 3-Acetylindol, 1-Methyl-3-acetylindol, 2-(1',3',3'-Trimethyl-2-indolinyliden)-acetaldehyd, 1-Methylpyrrol-2-aldehyd, 1-Methyl-2-acetylpyrrol, 4-Pyridinaldehyd, 2-Pyridinaldehyd, 3-Pyridinaldehyd, 4-Acetylpyridin, 2-Acetylpyridin, 3-Acetylpyridin, Pyridoxal, Chinolin-3-aldehyd, Chinolin-4-aldehyd, Antipyrin-4-aldehyd, Furfural, 5-Nitrofurfural, 2-Thenoyl-trifluor-aceton, Chromon-3-aldehyd, 3-(5'-Nitro-2'-furyl)-acrolein, 3-(2'-Furyl)-acrolein und Imidazol-2-aldehyd.

Besonders bevorzugt ist der aromatische Aldehyd ausgewählt aus der Gruppe bestehend aus 2,3-Dihydroxybenzaldehyd, 2,4-Dihydroxybenzaldehyd, 2,4-Dihydroxy-3-methyl-benzaldehyd, 2,4-Dihydroxy-5-methyl-benzaldehyd, 2,4-Dihydroxy-6-methyl-benzaldehyd, 2,4-Dihydroxy-3-methoxy-benzaldehyd, 2,4-Dihydroxy-5-methoxy-benzaldehyd, 2,4-Dihydroxy-6-methoxy-benzaldehyd, 2,5-Dihydroxybenzaldehyd, 2,6-Dihydroxybenzaldehyd, 3,4-Dihydroxybenzaldehyd, 3,4-Dihydroxy-2-methyl-benzaldehyd, 3,4-Dihydroxy-5-methyl-benzaldehyd, 3,4-Dihydroxy-6-methyl-benzaldehyd, 3,4-Dihydroxy-2-methoxy-benzaldehyd, 3,4-Dihydroxy-5-methoxy-benzaldehyd, 3,5-Dihydroxybenzaldehyd.

Ganz besonders bevorzugt ist der aromatische Aldehyd ausgewählt aus der Gruppe, bestehend aus 2,4-Dihydroxybenzaldehyd, 2,5-Dihydroxybenzaldehyd, 2,6-Dihydroxybenzaldehyd und 3,5-Dihydroxybenzaldehyd.

Zur Anpassung an das gewählte Verarbeitungsverfahren oder das Einsatzgebiet der photopolymerisierbaren

Zusammensetzung und zur Verbesserung der Druckbarkeit, Oberflächenhaftung, Viskosität, Filmbildung, Flexibilität, Härte, Kälte-, Hitze- und Witterungsbeständigkeit kann die Zusammensetzung oder die erste Mischung A verschiedene an sich bekannte Additive enthalten.

Daher umfasst die erste Mischung A in der photopolymerisierbaren Zusammensetzung optional ein Additiv.

Die Additive umfassen dabei Lösungsmittel, Füllsubstanzen, Farbstoffe, Weichmacher, Tenside, übliche Komponenten, die in Photopolymersystemen verwendet werden, polymere Binder, Netzmittel, Verlaufsmittel, Entschäumer, Haftvermittler, Oberflächenadditive, nanoskalige Teilchen, optische Aufheller oder Mischungen daraus.

Diese sollen sich gut einmischen lassen und den Beugungswirkungsgrad nicht verschlechtern. Nicht flüchtige Substanzen können den Beugungswirkungsgrad bei dünnen Schichten sogar noch dauerhaft verbessern, indem insbesondere solche Additive gewählt werden, die den Brechungsindexunterschied zwischen dem ethylenisch ungesättigten Monomer und den übrigen Komponenten der photopolymerisierbaren Zusammensetzung erhöhen. Wenn die Triglyceridkomponente einen niedrigeren Brechungsindex als die Komponente des ethylenisch ungesättigten Monomers besitzt, so sollte das Additive bzw. sollten die Additive ebenfalls einen möglichst niedrigen Brechungsindex besitzen. Daher kommen in diesem Fall neben bekannten Polymeren mit einem niedrigen Brechungsindex wie Polyvinylacetat besonders fluorierte oder silanisierte Polymere in Betracht. Um gute Diffusionseigenschaften zu erreichen, sollte das Molekulargewicht der in Betracht gezogenen Additive nicht zu hoch sein.

Die voranstehend erwähnten und nachfolgend im Einzelnen angegebenen Additive können im Allgemeinen in einer Menge von 0,01 bis 20 Gew.-%, bevorzugt 0,01 bis 10 Gew.-%, eingesetzt werden.

Die photopolymerisierbare Zusammensetzung oder die erste Mischung A kann einen Weichmacher enthalten, um die Modulation des Brechungsindex der mit Bild versehenen Zusammensetzung zu verstärken. Weichmacher können in Mengen eingesetzt werden, die von etwa 0,01 bis etwa 10 Gew.-% reichen, vorzugsweise 5 bis etwa 10 Gew.-%. Zu den geeigneten Weichmachern gehören Triethylenglycol, Triethylenglycoldiacetat, Triethylenglycoldipropionat, Triethylenglycoldicaprylat, Triethylenglycoldimethylether, Triethylenglycolbis(2-ethylhexanoat), Tetraethylenglycoldiheptanoat, Polyethylenglycol, Polyethylenglycolmethylether, Isopropylnaphthalin, Diisopropylnaphthalin,Polypropylenglycol, Glyceryltributyrat, Diethyladipat, Diethylsebacinat, Dibutylsuberinat, Tributylphosphat, Tris(2-ethylhexyl)phosphat, Brij® 30 [$C_{12}H_{25}(OCH_2CH_2)_4OH$], Brij® 35 [$C_{12}H_{25}(OCH_2CH_2)_{20}OH$], sowie n-Butylacetat.

Besonders bevorzugte Weichmacher sind Polyethylenglycol, Triethylenglykoldiethylhexanoat (3G8), Triethylenglycoldicaprylat, Tetraethylenglycoldiheptanoat, Diethyladipat, Brij® 30 und Tris(2-ethylhexyl)phosphat.

Falls gewünscht, können andere übliche Komponenten, die in PhotopolymerSystemen verwendet werden, mit den Zusammensetzungen und Elementen dieser Erfindung eingesetzt werden. Zu diesen Komponenten gehören: Optische Aufheller, ultraviolette Strahlung absorbierendes Material, thermische Stabilisatoren, Wasserstoff-Donoren, Sauerstoff-Fänger und Trennmittel. Diese Additive können auch Polymere oder Co-Polymere umfassen.

Zu den brauchbaren optischen Aufhellern gehören die im US-Patent 3 854 950 A offenbarten. Ein bevorzugter optischer Aufheller ist 7-(4'-Chlor-6'-diethylamino-1',3',5'-triazin-4'-yl)amino-3-phenylcumarin. Auch ultraviolette Strahlung absorbierende Materialien, die für diese Erfindung brauchbar sind, sind im US-Patent 3 854 950 A offenbart.

Zu den brauchbaren thermischen Stabilisatoren gehören: Hydrochinon, Phenidon, p-Methoxyphenol, Alkyl- und Aryl-substituierte Hydrochinone und Chinone, tert-Butylcatechin, Pyrogallol, Kupferresinat, Naphthylamine, β-Naphthol, Kupfer(I)-chlorid, 2,6-Di-tert-butyl-p-cresol, Phenothiazin, Pyridin, Nitrobenzol, Dinitrobenzol, p-Toluchinon und Chloranil. Brauchbar sind auch die in US-Patent 4 168 982 A beschriebenen Dinitroso-Dimere. Normalerweise ist auch ein Inhibitor für die thermische Polymerisation vorhanden, um die Stabilität bei der Lagerung der photopolymerisierbaren Zusammensetzung zu erhöhen.

Zu den als Kettenübertragungsreagenzien brauchbaren Wasserstoff-Donorverbindungen gehören: 2-Mercaptobenzoxazol, 2-Mercaptobenzothioazol etc. sowie verschiedene Arten von Verbindungen, z.B. (a) Ether, (b) Ester, (c) Alkohole, (d) Verbindungen, die allylischen oder benzylischen Wasserstoff enthalten wie etwa Cumol, (e) Acetale, (f) Aldehyde, und (g) Amide, wie offenbart in Spalte 12, Zeilen 18 bis 58 in US-Patent 3 390 996 A, auf die hierin ausdrücklich Bezug genommen wird.

Verbindungen, die sich als Trennmittel brauchbar erwiesen haben, sind beschrieben in US-Patent 4 326 010 A. Ein bevorzugtes Trennmittel ist Polycaprolacton.

Die photopolymerisierbare Zusammensetzung oder die erste Mischung A kann auch einen oder mehrere polymere Binder enthalten, der bzw. die ausgewählt ist aus der Gruppe umfassend Polymethylmethacrylat und Polyethylmethacrylat, Polyvinylester, wie Polyvinylacetat, Polyvinylacetat/-acrylat, Polyvinylacetat/-methacrylat und teilweise hydrolisiertes Polyvinylacetat, Ethylen/Vinylacetat-Copolymere, Vinylchlorid/Carbonsäurester-Copolymere, Vinylchlorid/Acrylsäureester-Copolymere, Polyvinylbutyral und Polyvinylformal, Butadien und Isoprenpolymere und Copolymere und Polyethylenoxide aus Polyglycolen mit einem durchschnittlichen Molekulargewicht von etwa 1.000 bis 1.000.000 g/mol, Epoxide, wie Acrylat- oder Methacrylatreste enthaltende Epoxide, Polystyrole, Celluloseester, wie Celluloseacetat, Celluloseacetatsuccinat und Celluloseacetatbutyrat, Celluloseether, wie Methylcellulose und Ethylcellulose, Polykondensate, wie Polycarbonate, Polyester, Polyamide, wie N-Methoxymethylpolyhexamethylenadipamid, Polyimide, Polyurethane. Die genannten polymeren Binder können z.B. in einer Menge von 0,001 bis 10 Gew.%, bezogen auf das

Gesamtgewicht der Zusammensetzung, eingesetzt werden.

Die photopolymerisierbare Zusammensetzung oder die erste Mischung A kann auch ein oder mehrere Netzmittel (insbesondere Fluor-Carbonpolymere, wie zum Beispiel Schwego-Fluor 8038™, oder Fluorotenside, wie zum Beispiel 3M Fluorad FC-4430™), Verlaufsmittel (insbesondere Glykolsäure-n-butylester oder Polyether-modifizierte Polydimethylsiloxane, wie zum Beispiel ADDID 130™), Entschäumer (insbesondere Entschäumer auf Fluorsilikonölbasis, wie zum Beispiel ADDID 763™), Haftvermittler (insbesondere Diamino-Trimethoxy-funktionelle Silanhaftvermittler, wie zum Beispiel ADDID 900™ oder Glycidyl-Trimethoxytrifunktionelle Silanhaftvermittler, wie zum Beispiel ADDID 911™, Vinyltriethyoxysilan oder 3-Methacryloxypropyltrimethoxysilan), oder Oberflächenadditive (insbesondere Polyether-modifizierte acrylfunktionelle Polydimethylsiloxane, wie zum Beispiel BYK-UV 3500™, Polyether-modifizierte Polydimethylsiloxane, wie zum Beispiel BYK-UV 3510™ oder Polyether-modifizierte acrylfunktionelle Polydimethylsiloxane, wie zum Beispiel BYK-UV 3530™) enthalten. Die genannten Produkte mit den Handelsnahmen "ADDID" bzw. "BYK" sind von Wacker bzw. BYK Chemie erhältlich.

Die photopolymerisierbare Zusammensetzung oder die erste Mischung A kann auch nanoskalige Teilchen wie z.B. $TiO_2$, $SiO_2$ oder Au enthalten, die ggf. an Monomere gekoppelt sein können (solche Materialien sind z.B. unter der Handelsbezeichnung "Nanocryl" erhältlich).

Vorzugsweise kann das Additiv ein Aminsynergist sein. Ein Aminsynergist kann in Kombination mit anderen Photoinitiatoren die Aushärtungsgeschwindigkeit von UV-Lacken erhöhen (siehe DE 60216490 T2).

Vorzugsweise kann das Additiv ein Peroxid sein. Ein thermisch aktivierbarer Peroxid kann in Kombination mit anderen Photoinitiatoren die Aushärtung von UV-Lacken besonders in Schattenbereichen verbessern (siehe US 5017406 A oder DE 60030223 T2).

Vorzugsweise kann das Additiv auch ein Marker ausgewählt aus Fluoreszenzpigmenten oder Lanthanidverbindungen sein. Als Lanthanidverbindungen können beispielsweise Europium oder Terbium Trisdipicolinat Komplexe verwendet werden.

Unter einem Marker wird im Sinne der vorliegenden Erfindung eine forensisch nachweisbare Substanz verstanden, über die die Authentizität oder die Herkunft eines Produktes bzw. dessen Produzent oder Verkäufer ermittelt werden kann. Vorausgesetzt, dass die zu erzeugenden Schichten dick genug sind um die entsprechenden Mikropartikel einzubetten, können auch kleine individualisierte Partikel, buntes Mikroplastik auch Taggant genannt, eingebracht werden

Vorzugsweise ist die photopolymerisierbare Zusammensetzung bei Standarddruck in einem Bereich von 15°C bis 150°C, ganz besonders bevorzugt 20°C bis 120°C flüssig.

Vorzugsweise umfasst der Polyether einen Polyether basierend auf einem Poly(ethylen glycol)-block-poly(propylen glycol)-block-poly(ethylen glycol)

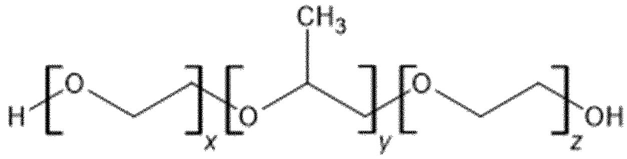

In der Formel ist x = 1-500, y = 1-500 und z = 1-500, vorzugsweise x = 1-200, y = 1-200 und z = 1-200, besonders bevorzugt x = 5-100, y = 5-100 und z = 5-100. Das zahlenmittlere Molekulargewicht beträgt vorzugsweise 500-2000, bevorzugter 750-1500, besonders bevorzugt 900-1300.
oder
Poly(Bisphenol-A-co-epichlorhydrin) mit Glycidyl-Endgruppen ("gylcidyl end capped")

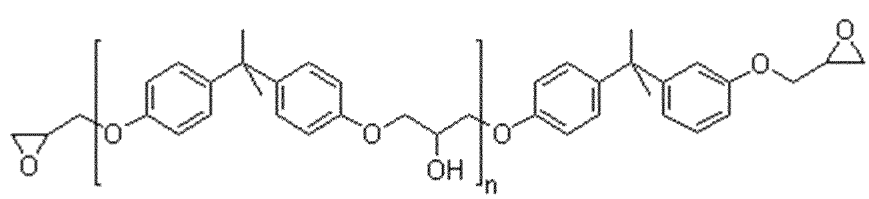

In der Formel ist n = 1-500, vorzugsweise n = 1-200, besonders bevorzugt n = 5-100. Das zahlenmittlere Molekulargewicht beträgt vorzugsweise 500-2000, bevorzugter 750-1500, besonders bevorzugt 900-1300. Das Epoxy-Äquivalenzgewicht beträgt vorzugsweise 100-1000, bevorzugter 250-750, besonders bevorzugt 500-600.

Vorzugsweise umfasst die erfindungsgemäße photopolymerisierbare Zusammensetzung:

I) 60-95 Gew.-% einer ersten Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv,

II) 5-40 Gew.% mindestens eines Polyethers, wobei die Mengen von I) und II) 100 Gew.-% ergeben.

Besonders bevorzugt ist eine photopolymerisierbare Zusammensetzung umfassend:

I) 60-95 Gew.-% einer ersten Mischung A, umfassend

a) 70-98 Gew.-% mindestens eines Monomers M, umfassend mindestens eine ethylenisch ungesättigte Gruppe,
b) 0,5-24 Gew.-% mindestens eines Triglycerids und/oder eines modifizierten Triglycerids,
c) 0,1-5 Gew.-% mindestens eines Photoinitiators,
d) 0,1-2 Gew.-% mindestens eines aromatischen Aldehyds und/oder aliphatischen Aldehyds und
e) 0 bis 10 Gew.-% eines Additivs, vorzugsweise 0,01 bis 10 Gew.-% eines Additivs, wobei die Mengen von a) bis e) 100 Gew.-% ergeben und

II) 5-40 Gew.-% mindestens eines Polyethers, wobei die Mengen von I) und II) 100 Gew.-% ergeben.

Ganz besonders bevorzugt ist eine photopolymerisierbare Zusammensetzung umfassend:

I) 60-95 Gew.-% einer ersten Mischung A, umfassend

a) 70-98 Gew.-% mindestens eines Monomers M, umfassend mindestens eine ethylenisch ungesättigte Gruppe,
b) 0,5-24 Gew.-% mindestens eines Triglycerids und/oder eines modifizierten Triglycerids,
c) 0,1-5 Gew.-% mindestens eines Photoinitiators und eines weiteren Photoinitiators aus einem Co-Photoinitiator mit einem Farbstoff, wobei der Farbstoff ausgewählt ist aus der Gruppe, bestehend aus Acriflavinen, Diaminoacridinen, Rhodamin B, Safranin-O, Diethylsafranin und Methylenblau, und der Co-Photoinitiator ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat,
oder Mischungen daraus.
d) 0,1-2 Gew.-% mindestens eines aromatischen Aldehyds und/oder aliphatischen Aldehyds und
e) 0 bis 10 Gew.-% eines Additivs, vorzugsweise 0,01 bis 10 Gew.-% eines Additivs, wobei die Mengen von a) bis e) 100 Gew.-% ergeben
und

II) 5-40 Gew.-% mindestens eines Polyethers basierend auf einem

Poly(ethylen glycol)-block-poly(propylen glycol)-block-poly(ethylen glycol)

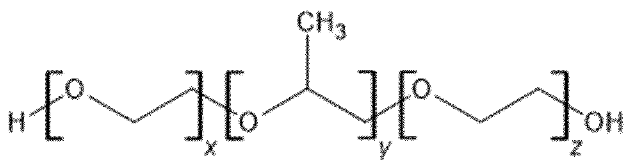

wobei in der Formel x = 1-500, y = 1-500 und z = 1-500, vorzugsweise x = 1-200, y = 1-200 und z = 1-200, besonders bevorzugt x = 5-100, y = 5-100 und z = 5-100 ist und/oder das zahlenmittlere Molekulargewicht vorzugsweise 500-2000, bevorzugter 750-1500, besonders bevorzugt 900-1300 beträgt,
oder
Poly(Bisphenol-A-co-epichlorhydrin) mit Glycidyl-Endgruppen ("gylcidyl end capped")

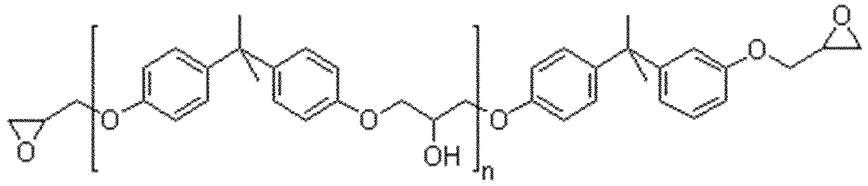

wobei in der Formel n = 1-500, vorzugsweise n = 1-200, besonders bevorzugt n = 5-100 ist und/oder das zahlenmittlere Molekulargewicht vorzugsweise 500-2000, bevorzugter 750-1500, besonders bevorzugt 900-1300 beträgt und/oder das Epoxy-Äquivalenzgewicht vorzugsweise 100-1000, bevorzugter 250-750, besonders bevorzugt 500-600 beträgt, wobei die Mengen von I) und II) 100 Gew.-% ergeben.

Insbesondere bevorzugt ist eine photopolymerisierbare Zusammensetzung umfassend:

I) 60-95 Gew.-% einer ersten Mischung A, umfassend

a) 70-98 Gew.-% mindestens eines Monomers M, umfassend Verbindungen der folgenden Formel

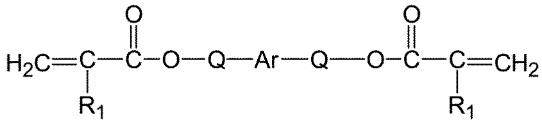

worin $R_1$, Q und Ar die oben angegebene Bedeutung haben,
b) 0,5-24 Gew.-% mindestens eines Triglycerids und/oder eines modifizierten Triglycerids, wobei das modifizierte Triglycerid ausgewählt ist aus Gruppe bestehend aus den oben genannten Formeln (A), (B), (C) und Gemischen davon,
c) 0,1-5 Gew.-% mindestens eines Photoinitiators, ausgewählt aus der Gruppe bestehend aus 1,2-Octandion-1-[4-(phenylthio)-phenyl]-2-(O-benzoyloxim), (1-[9-Ethyl-6-(2-methylbenzoyl)-9H-carbazol-3-yl]ethanon-O-acetyloxim, Methylbenzoylformiat, 2,4,6-Trimethylbenzoyl-diphenyl-phosphinoxid, Ethyl-(2,4,6-trimethylbenzoyl)-phenylphosphinat, 2-Hydroxy-2-methyl-1-phenylpropanon, eine Mischung aus 2-Hydroxy-2-methyl-1-phenylpropanon (80%) und 1- Hydroxycyclohexyl-phenylketon (20%), 1-Hydroxycyclohexyl-phenylketon), Bis(2,4,6-trimethylbenzoyl)phenylphosphinoxid), eine Mischung aus 2-Hydroxy-2-methyl-1-phenylpropanon sowie Bis(2,4,6-trimethylbenzoyl)phenylphosphinoxid und Ethyl(2,4,6-trimethylbenzoyl)-phenylphosphinat), 4,4'-Dimethyl-diphenyl-iodonium-hexafluorphosphat,
und mindestens eines Photoinitiators aus einem Co-Photoinitiator mit einem Farbstoff, wobei der Farbstoff ausgewählt ist aus der Gruppe, bestehend aus Acriflavinen, Diaminoacridinen, Rhodamin B, Safranin-O, Diethylsafranin und Methylenblau, und der Co-Photoinitiator ausgewählt ist aus der Gruppe, bestehend aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat , oder Mischungen daraus.
d) 0,1-2 Gew.-% mindestens eines aromatischen Aldehyds ausgewählt aus der Gruppe, bestehend aus 2,4-Dihydroxybenzal dehyd, 2,5-Dihydroxybenzaldehyd, 2,6-Dihydroxybenzaldehyd und 3,5-Dihydroxybenzaldehyd,
e) 0 bis 10 Gew.-% eines Additivs, vorzugsweise 0,01 bis 10 Gew.-% eines Additivs, wobei die Mengen von a) bis e) 100 Gew.-% ergeben und

II) 5-40 Gew.-% mindestens eines Polyethers basierend auf einem

Poly(ethylen glycol)-block-poly(propylen glycol)-block-poly(ethylen glycol)

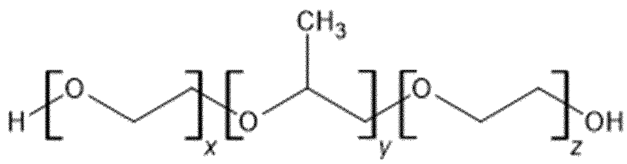

wobei in der Formel x = 1-500, y = 1-500 und z = 1-500, vorzugsweise x = 1-200, y = 1-200 und z = 1-200, besonders bevorzugt x = 5-100, y = 5-100 und z = 5-100 ist und/oder das zahlenmittlere Molekulargewicht vorzugsweise 500-2000, bevorzugter 750-1500, besonders bevorzugt 900-1300 beträgt,
oder
Poly(Bisphenol-A-co-epichlorhydrin) mit Glycidyl-Endgruppen ("gylcidyl end capped")

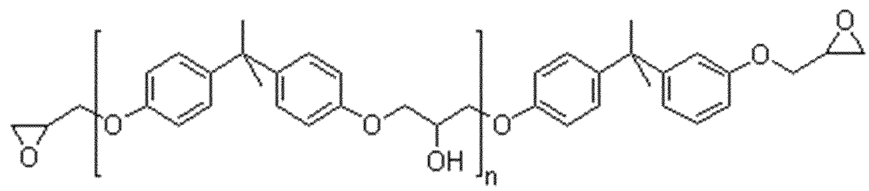

wobei in der Formel n = 1-500, vorzugsweise n = 1-200, besonders bevorzugt n = 5-100 ist und/oder das zahlenmittlere Molekulargewicht vorzugsweise 500-2000, bevorzugter 750-1500, besonders bevorzugt 900-1300 beträgt und/oder das Epoxy-Äquivalenzgewicht vorzugsweise 100-1000, bevorzugter 250-750, besonders bevorzugt 500-600 beträgt,
wobei die Mengen von I) und II) 100 Gew.-% ergeben.

In einer weiteren Ausgestaltung umfasst die Erfindung ein Element, enthaltend eine Komponente, die erhältlich ist durch Einwirkung von (aktinischer) UV/VIS-Strahlung auf die erfindungsgemäße photopolymerisierbare Zusammensetzung.

Vorzugsweise umfasst das erfindungsgemäße Element eine Komponente, die transparente und/oder transluzente Bereiche aufweist.

Wird die photopolymerisierbare Zusammensetzung in einem Zeitraum von mindestens 1s bis 5 min, vorzugsweise von 2s bis 2 min mit einer Lichtquelle von höchstens 50 $mW/cm^2$ belichtet, kann sie milchig werden. Es entsteht eine Mattscheibe, deren Streueigenschaften durch die gewählte Belichtungsmethode (Dauer, Intensität, Temperatur, etc.) gezielt und lokal verändert werden kann. Auch macht es einen Unterschied, ob mit kohärentem Laserlicht (Speckles) oder weißem bzw. UV-Licht belichtet wird. Durch die Specklegröße kann z.B. gezielt die Körnigkeit eingestellt werden. Die erreichbare Auflösung ist sehr hoch. Daher können vorzugsweise Komponenten bereitgestellt werden, die transparente und/oder transluzente Bereiche umfassen.

Mit einer Maskenbelichtung können so beliebige Strukturen, Texte und Bilder erzeugt werden, die unabhängig von einer holographischen Wiedergabe über ihre Mattheit zu erkennen sind.

In einer weiteren Ausführungsform betrifft die Erfindung die Verwendung des erfindungsgemäßen Elements als Folie, Linse, Gitter, Prisma, Spiegel, Strahlteiler, Diffusor, Oberflächenrelief, Membran, Filter oder Sensor.

Durch die Belichtung mit einem gerichteten Strahl und einem Strichmuster können milchige Lamellen, die senkrecht oder schräg im regelmäßigen Abstand in der Schicht stehen, belichtet werden um eine Jalousiefolie zu erzeugen. Diese Folie ist in einer Richtung, die dem Belichtungswinkel entspricht, transparent und ansonsten milchig. So eine Folie kann z.B. als Blickschutzfolie für Bildschirme verwendet werden.

Das Ganze kann zudem mit holographischen Eigenschaften kombiniert werden, indem die noch nicht belichteten Bereiche schnell und transparent holographisch belichtet werden. Die entstandene Folie reagiert dann z.B. auf einen bestimmten Beleuchtungswinkel. Strahlumlenkung und Streuung kann aufeinander abgestimmt werden. Auch die Verwendung von mehreren Schichten die nacheinander aufgetragen und unterschiedlich belichtet werden ist denkbar.

Hinzukommt, dass gleichzeitig eine Oberfläche z.B. eine Linsenstruktur abgeformt werden kann. So ist es möglich, Strukturen zu erzeugen, die z.B. das Licht von einem LED-Array bündeln und als gerichteten Lichtstrahl und anderes Licht, von LED's die sich nicht im Linsenraster befinden, als Streulicht wiedergeben. Diese Streuung kann durch die matten Bereiche ausserhalb der Linsenstrahlengänge verstärkt werden. Die Verwendung eine Bienenwabenstruktur mit matten Wänden wäre eine mögliche Ausführungsform.

Eine Anwendung wären Lichtquellen, die den natürlichen Himmel imitieren und direktes gerichtetes weißgelbes Sonnenlicht sowie blaues Streulicht abgeben. Das LED-Array dieses künstlichen "Dachfensters" könnte natürlich noch die Helligkeit und Farbe wie bei einem Bildschirm lokal variieren, so dass unterschiedliche Lichtstimmungen, Tageszeiten, bewölkter Himmel, und vorbeiziehende Wolken simuliert werden könnten.

Das blaue Licht könnte auch durch ein Reflexionshologramm aus den gerichteten Weißlichtstrahl gefiltert und auf die Streuzentren oder -flächen gelenkt werden. All dies, Abformung, Lichtbündelung, Streuung und Hologramm kann mit diesem Photopolymermaterial in einem Belichtungsvorgang realisiert oder durch wiederholtes Auftragen und Belichten in mehreren Schichten kombiniert werden.

Auch beim Automobil wird gerichtetes und gestreutes Licht benötigt. Gerichtetes Licht für die Scheinwerfer, die die Straße ausleuchten und gestreutes Licht, wie bei Blinker, Brems- oder Rückleuchten, die für die anderen Verkehrsteilnehmer in einem großen Winkelbereich erkennbar sein sollen. Durch den Einsatz der oben beschriebenen und

erklärten Spezialfolie, könnte z.B. ein Scheinwerfer so konstruiert werden, dass er über seine komplette Fläche ebenso auch die Funktion eines Blinkers erfüllt. Der Scheinwerfer würde gleichzeitig das gerichtete Scheinwerferlicht und wenn nötig in allen Richtungen gestreutes gelbes Licht abgeben können.

Besonders bevorzugt ist ein erfindungsgemäßes Element, umfassend ein Hologramm, das erhältlich ist durch die Einwirkung einer holographische Information tragenden, modulierenden Strahlung auf die erfindungsgemäße photopolymerisierbare Zusammensetzung.

Besonders bevorzugt ist ein Element, umfassend ein Hologramm, wobei das Hologramm mit einer Versiegelungsschicht versehen ist.

Vorzugsweise wird auf der Versiegelungsschicht ein Quellstoff aufgebracht. Ein Quellstoff im Sinne der vorliegenden Erfindung ist ein Stoff der mittels Diffusion Einschrumpfen oder Quellen des Hologramms bewirkt.

Dadurch, dass die gehärtete photopolymerisierbare Zusammensetzung eine begrenzte Elastizität hat, kann sie nur in einem bestimmten Bereich Schrumpfen und Quellen. Wird die untere Grenze erreicht, so kann das verbliebene Rizinusöl nicht mehr von alleine austreten.

Umgekehrt können aber auch Stoffe eindiffundieren und die aus der erfindungsgemäßen photopolymerisierbaren Zusammensetzung hergestellte Schicht quellen. Ein grünes Reflexionshologramm kann z.B. so in ein Rotes verwandelt werden.

Die gleiche Methodik ist auch mit dem Blitzlicht verwendbar. Aufgebrachte Stoffe verdampfen und dringen blitzschnell in die Schicht ein. Dies funktioniert erstaunlicherweise auch dann, wenn die Photopolymerschicht schon von einer UV-Lack Schicht versiegelt ist. Da diese Versiegelungsschicht verhindert, dass das Rizinusöl austritt, findet kein Austausch statt und die gequollenen Bereiche bleiben permanent erhalten.

Dies kann wunderbar dazu genutzt werden, um ein fertiges Hologramm nachträglich zu individualisieren. Der Quellstoff wird dazu zum Beispiel mit einem gängigen Tintenstrahldruckverfahren aufgebracht. Durch den nachträglichen starken UV-Blitz, verdampfen die wirksamen Substanzen und erzeugen durch das Eindringen dort wo sie aufgebracht worden sind eine Quellung und lokale Farbänderungen im Hologramm. Die eingebrachte Information kann z.B. ein Bild, eine Nummer oder eine Beschriftung sein. Da diese Änderungen nicht rückgängig gemacht werden können und nur das Hologramm beeinflussen, ist dieses schnelle und einfache Verfahren eine gute Möglichkeit die Fälschungssicherheit von Ausweisen, Siegeln oder Vignetten zu erhöhen. Besonders bei den Produkten, die am Ausgabeort noch individualisiert werden und wo dies einfach durchführbar sein muss.

Anstatt eines Tintenstrahldruckers und eines Blitzes kann auch ein Thermosublimationsdrucker verwendet werden, der die Quellstoffe über ein entsprechendes Druckerband verdampft.

Ein besonders großer Unterschied kann erreicht werden, wenn das Hologramm vorher geschrumpft wurde. Ein vorher rein grünes Hologramm, welches nur mit einem grünen Laser belichtet wurde, kann so nachträglich durch Schrumpfen und Quellen, blaue, grüne und rote Stellen aufweisen.

Auch für technische Zwecke kann dies genutzt werden. z.B. für ein Reflexionshologramm, welches für die Wiedergabe einer farbigen Projektion für die Grundfarben feine rote, grüne und blaue Hologrammlinien aufweisen soll.

Bei dicken Schichten kann ein Konzentrationsgefälle entstehen. Das eingedrungene Material quellt dann die obere Schicht stärker als die tiefen Schichten. Dies führt im Absorptionsspektrum zu einer Verbreiterung des Absorptionspeaks. Auch ein Doppelpeak ist möglich, wenn der Quellbereich abrupt endet und die Stärke der Quellung nicht allmählich abnimmt.

Eine Verbreiterung des Peaks besagt, dass ein größerer Wellenlängenbereich reflektiert wird und auch der Wiedergabewinkel für eine bestimmte Wellenlänge breiter wird. Die Möglichkeit diese wichtigen Parameter eines Hologramms nachträglich ändern zu können ist für viele technische Anwendungen nutzbar. z.B. für HUD's die auch unter einen größeren Wiedergabe- bzw. Betrachtungswinkel funktionieren sollen.

Da die photopolymerisierbare Zusammensetzung vorzugsweise unter Standardbedingungen flüssig ist und beim Belichten gehärtet wird, ist dies, wie bei den meisten Stoffen die so einen Phasenübergang machen, mit einem gewissen Schrumpf verbunden. Durch diesen Härtungsschrumpf entsteht bei der holographischen Belichtung auf der Oberfläche ein Relief, welches dem Interferenzmuster entspricht. Die Entstehung kann dadurch erklärt werden, dass die inerte Komponente, die keine Phasenänderung durchmacht, vermehrt in den dunklen zunächst unbelichteten Bereichen des Interferenzmusters auftritt und dort deswegen ein geringerer Schrumpf zu verzeichnen ist.

Bemerkenswert ist, dass beim Belichten eines Reflexionshologrammes, die Oberfläche eine eher sägezahnförmige und nicht sinusoidale Struktur aufweist. Diese Struktur kann daher sehr gut als Vorlage für ein Nickelshim zur Herstellung von Prägehologrammen dienen. Die Master für diese Shims werden normalerweise mit Hilfe eines Photoresistlackes und durch ein spezielles Ätzverfahren hergestellt. Das Generieren von den gewünschten Sägezahnstrukturen ist dabei nicht leicht und wird als Blazeverfahren bezeichnet.

Mit der photopolymerisierbaren Zusammensetzung geht es dagegen viel einfacher, auf das aufwendige Ätzverfahren kann verzichtet werden. Der Schrumpf und die Strukturtiefe kann noch, wie weiter oben schon beschrieben, durch die geringe Zugabe von Lösemitteln verstärkt werden. Auch das Auswaschen von Rizinusöl durch das Baden in einer Ethanol-Wasser-Lösung verstärkt das Profil.

So ein eigentlich als Reflexionshologramm belichtete Schicht kann dank der gebildeten Oberflächenstrukturen auch direkt als Transmissionshologramm verwendet werden. Mit dieser Methode lässt sich z.B. sehr einfach ein Inline-Transmissionshologramm realisieren. Der Belichtungsaufbau könnte dabei so aussehen, dass ein paralleler Lichtstrahl senkrecht durch die photopolymerisierbare Zusammensetzung geht, direkt dahinter auf einen Hohlspiegel trifft der das Licht zurückwirft, das dann mit der einfallenden Welle interferiert. Wird das fertige Hologramm nun mit der ebenen Welle durchleuchtet, wird ein Teil des Lichtes durch das entstandene Oberflächenrelief gebeugt und hinter der Platte fokussiert. An der Stelle, wo das fokussierte Licht und die ebene Welle ein Intensitätsverhältnis von 50% haben, kann nun sehr gut in einem zweiten Schritt ein sehr lichtstarkes Volumen-Transmissionshologramm aufgezeichnet werden.

Dieser Trick vereinfacht die Herstellung eines solchen Masters sehr. Denn sonst hätte der Belichtungsaufbau zwei Strahlengänge und einen halbdurchlässigen Spiegel gebraucht, ganz abgesehen von der aufwendigen Nachbehandlung einer Photoresistschicht.

Interessant ist, dass aber auch bei Maskenbelichtungen Höhenstrukturen entstehen. Und zwar abhängig davon, welcher Bereich mit Laserlicht und welche Stellen nur mit UV-Licht belichtet wurden. Durch die Art der Belichtung können so auch Reliefs erzeugt werden. Je nach dem Auflösungsvermögen der Maskentechnik können beliebige Strukturen erzeugt werden. Denkbar ist der Einsatz dieser Technik zur Erzeugung von Mikrostrukturen.

Besonders bevorzugt wird die Verwendung des erfindungsgemäßen Elements für ein Head-up-Display, eine Datenbrille, ein Lichtleitsystem, ein Spektrometer, ein Detektionssystem, ein Sicherheitselement oder ein Label.

Abhängig von den verwendeten Quellchemikalien, kann sich deren Verteilung in der Schicht temperaturabhängig noch zeitlich verändern. So kann bei einigen Substanzen beobachtet werden, dass die Spitzen eines Doppelpeaks mit der Zeit aufeinander zuwandern und miteinander verschmelzen. Oft trifft dieser Effekt erst auf, wenn ein bestimmter Temperaturwert z.B. der Schmelzpunkt dieser Chemikalie überschritten wird.

Da die spektrometrische Vermessung sehr einfach zu interpretieren ist, kann das Vor- oder Nichtvorhandensein eines Doppelpeaks oder die Wellenlängenverschiebung eines einzelnen Peak zuverlässig darüber Auskunft geben, ob die Probe längerer Zeit einer höheren Temperatur ausgesetzt war. Dieser Effekt könnte daher für die Überprüfung der Einhaltung einer Kühlkette dienen.

Der Messpunkt kann dabei klein sein und in ein Etikett integriert werden. Auch ist es möglich ein mit dem Auge erkennbare Information zu erzeugen. Dazu muss die behandelte Fläche einfach in ein Hologramm integriert werden, welches so belichtet wurde, dass es die selbe Wellenlänge reflektiert. Spätere Farbabweichungen könnten z.B. einen Schriftzug oder Symbol erscheinen lassen, das darauf hinweist, dass das Produkt einer höheren Temperatur ausgesetzt war.

Umgekehrt ist es natürlich auch möglich, dass das Etikett so gestaltet wird, dass die Schrift oder das Bild mit der Zeit verschwindet.

Auch die Migration des Rizinusöls in einer darunter liegenden Absorberschicht des applizierten Hologrammetikettes kann dazu dienen über den Schrumpf und den damit verbundenen Farbänderungen gegenüber den versiegelten Bereichen ein Ablaufen der Mindesthaltbarkeit oder einer anderen Zeitspanne anzuzeigen. Besteht die Absorberschicht aus Papier, so kann durch das Eindringen des Rizinusöles die Papiertransparenz geändert werden und ein vom Hologramm unabhängig lesbarer Schriftzug entstehen. Dieser Effekt könnte auch dazu genutzt werden, auf einen Dokument nachträglich eine Art Wasserzeichen zu integrieren. Dazu wird das entsprechend präparierte Hologramm einfach mit einem Heißsiegelverfahren auf das Dokument appliziert. Durch die Übereinstimmung des Wasserzeichens mit der Hologrammänderung wird eine höhere Fälschungssicherheit erreicht.

Die Eigenschaften der photopolymerisierbaren Zusammensetzung, dass es zu temperatur-, druck- und belichtungsabhängigen Phasenseparationen zwischen dem Öl und Monomer kommt, kann dazu genutzt werden poröse Lackschichten zu erzeugen. Die Porengröße kann über die Belichtungsmethode und das Mischungsverhältnis variiert werden. Die Poren entstehen durch die Phasentrennung des Gemisches an den Stellen, wo sich das Rizinusöl in kleinen Bläschen sammelt. Das nicht gebundene Rizinusöl kann nach dem Belichten ausgewaschen werden. Übrig bleibt ein Polymergerüst dessen Durchlässigkeit von der erzielten Struktur abhängt. Das Gerüst kann natürlich auch wieder mit einem anderen Material gefüllt oder beschichtet werden, so dass für die Anwendung optimierte Komposit-Membranen entstehen.

Auch zur Herstellung saugfähiger mikroporösen Schichten kann die photopolymerisierbare Zusammensetzung genutzt werden und eventuell Anwendung für Spezialpapiere (Tintenstrahldrucker) oder für die weiter oben beschriebene Absorberschicht finden.

Mit der photopolymerisierbaren Zusammensetzung lassen sich auch wasserdichte und atmungsaktive Folien herstellen, um die umwelt- und gesundheitsschädlichen per- und polyfluorierten Membranen zu ersetzen. Vorzugsweise können auch Filter für Atemmasken mit spezifizierter Porengröße angefertigt werden können. Die Möglichkeit die Porengröße belichtungstechnisch zu variieren, kann sehr hilfreich sein um mehrstufige Filterschichten von grob nach fein zu generieren. Dies könnte ein frühzeitiges Verstopfen der feinsten Membranen verhindern.

Auch dass Hologramme als Biosensoren für den Nachweis von bestimmten Eiweißstoffen wie toxische Proteine, Antigenen und Antikörper verwendet werden können ist bekannt.

Die Verwendung von Rizinusöl hat einige Vorteile. Viele Antigene wie z.B. die Lipopolysaccharide haben ein lipophiles Ende, mit denen sie sich normalerweise in den Zellmembranen verankern. Sie könnten aber auch auf einen Transmissionshologramm vermehrt in den Bereichen anhaften, wo sich das Rizinusöl befindet. Die passenden Antikörper, die dann wiederum vermehrt an den Antikörpern koppeln, würden lokal und periodisch den Brechungsindex und damit den Beugungswirkungsgrad des Hologramms ändern und könnten dadurch delektiert werden.

Das fertige Element kann vorzugsweise als Etikett oder Label verwendet werden, welche den Nachweis optisch für das Auge erkennbar signalisieren, indem ein Helligkeitkontrast gegenüber den nicht aktiven geschützten Hologrammanteil entsteht, der nicht mit den Antikörpern in Berührung kommt.

Eine Ausführungsform könnte der Einsatz in einer Atemschutzmaske sein, der das Vorhandensein des gesuchten Antikörper, Virus oder Protein in der Atemluft registrieren könnte. Eventuell könnten auch ein Art Pflaster so ein holographischen Sensor enthalten um spezifische Biomoleküle auf der Haut oder in der Luft nachzuweisen.

Ein weiterer Gegenstand der Erfindung ist ein Verfahren zur Bildung eines lichtbeständigen Hologramms in einer photopolymerisierbaren Schicht auf einer Substratoberfläche, umfassend die Einwirkung einer eine holographische Information tragenden, modulierten Strahlung auf eine Schicht der erfindungsgemäßen photopolymerisierbaren Zusammensetzung.

Vorzugsweise erfolgt in dem erfindungsgemäßen Verfahren die Einwirkung der modulierten Strahlung im Kontaktkopierverfahren.

Vorzugsweise wird in dem erfindungsgemäßen Verfahren die photopolymerisierbare Zusammensetzung innerhalb einer Minute aufgetragen und belichtet.

## Beispiele

Im Folgenden wird die Erfindung anhand von Beispielen näher erläutert. Aus dem Stand der Technik ist eine Zusammensetzung gemäß Tabelle 1 bekannt.

Tabelle 1

| **Vergleichsbeispiel VB1** | | | |
|---|---|---|---|
| **Menge[g]** | **Menge[%]** | **Bezeichnung** | **CAS** |
| 91,93 | 91,93 % | SR 349 (ethoxyliertes Bisphenol-A-Diacrylat) | 64401-02-1 |
| 0,03 | 0,03 % | Safranin-O (3,7-Diamino-2,8-dimethyl-5-phenyl-phenaziniumchlorid) | 477-73-6 |
| 0,34 | 0,34 % | CGI 7460 (Tetrabutylammonium-Tris(3-flourphenyl)hexylborat, SEC LCA 1460, BASF) | |
| 3,75 | 3,75 % | Rizinusöl | 8001-79-4 |
| 3,75 | 3,75 % | Palmkernöl | 8023-79-8 |
| 0,2 | 0,20 % | Schwego-Fluor 8038 (ethanolische Lösung eines Fluortensids auf Polyetherbasis) von der Fa. Schwegmann | - |
| | | | |
| 100 | 100,00 % | | |

Die Zusammensetzung ist aus der EP 1 779 196 B1 bekannt.

## Erfindungsgemäße Beispiele

Als besseres Bindemittel für das Rizinusöl, um ein Ausschwitzen während der Belichtung zu verhindern, erwies sich das Hedipin R/2000." Ein bei Raumtemperatur wachsartiges ethoxyliertes Rizinusöl. Es konnte bei gleicher Wirkung in geringerer Menge als das Palmkernöl zugesetzt werden. Dies verbesserte die Klarheit der belichteten Mischung. Auch der Verzicht auf das Schwego-Fluor brachte in dieser Hinsicht eine Verbesserung.

Der Rizinusölanteil konnte erstaunlicherweise durch die Zugabe von einer geringen Menge 2,4 Dihydroxybenzaldehyd signifikant erhöht werden. Was eine merkliche Verbesserung des erreichbaren Delta-n-Wertes brachte. Die Rezeptur wird als monomerhaltige Mischung MM1 in Tabelle 2 beschrieben.

Tabelle 2

| Monomerhaltige Mischung MM1 | | | |
|---|---|---|---|
| **Menge[g]** | **Menge[%]** | **Bezeichnung** | **CAS** |
| 35 | 79,46 % | SR 349 (ethoxyliertes Bisphenol-A-Diacrylat) | 64401-02-1 |
| 7 | 15 , 89 % | Rizinusöl | 8001-79-4 |
| 0,2 | 0,45 % | SEC LCA 1460 (Tetrabutylammonium-Tris(3-flour-phenyl)hexylborat) | |
| 0,4 | 0,91 % | Irgacure® OXE01 (1,2-Octandion-1 -[4-(phenylthio)-phenyl]-2-(O-benzoyloxim) | 253585-83-0 |
| 0,25 | 0,57 % | 2,4 Dihydroxybenzaldehyd | 95-01-2 |
| 1,2 | 2,72 % | Hedipin R/2000 (PEG-200 castor oil) | 61791-12-6 |
| | | | |
| 44,05 | 100,00 % | | |

Eine weitere Verbesserung des Delta-n Wertes bzw. des Beugungswirkungsgrades bei gleicher Schichtdicke konnte durch das Hinzufügen einer BPA-Polymer / Poloxamer Mischung erreicht werden (siehe Tabelle 3). Vorteilhaft ist auch, dass dadurch die optimale Belichtungstemperatur von vorher 25°-26°C auf eine gängige Raumtemperatur von 21°-22°C sinkt."

SEC LCA 1460 ist nur eine neue Bezeichnung für das ursprüngliche CGI 7460. Der Farbstoff wird als lösemittelfreies Konzentrat (siehe Tabelle 4) zugegeben und ist nicht in den monomerhaltigen Mischungen (Tab. 2 und 3) enthalten.

Tabelle 3

| Monomerhaltige Mischung MM2 | | | |
|---|---|---|---|
| **Menge[g]** | **Menge[%]** | **Bezeichnung** | **CAS** |
| 6 | 12,00 % | Poly(Bisphenol A-coepichloro- hydrin), glycidyl end-capped, $M_n \sim 1.075$, Epoxy-Äquivalenzgewicht = 525 - 550 | 25036-25-3 |
| 4 | 8,00 % | Poly(ethylene glycol)-blockpoly(propylene glycol)-blockpoly(ethylene glycol) $M_n \sim 1.100$ | 9003-11-6 |
| 40 | 80,00 % | monomerhaltige Mischung MM1 | |
| | | | |
| 50 | 100,00 % | | |

Tabelle 4

| Farbstoffkonzentrat FK1 | | | |
|---|---|---|---|
| **Menge[g]** | **Menge[%]** | **Bezeichnung** | **CAS** |
| 0,97 | 4,85 % | EFKA PX 4701 acrylic block copolymer von der Fa. BASF | |
| 1,94 | 9,70 % | N-Hydroxyethylacrylam id | 7646-67-5 |
| 16,45 | 82,25 % | PEG-200, $M_n \sim 200$ | 25322-68-3 |
| 0,64 | 3,2 % | Methylenblau | 61-73-4 |
| | | | |
| 20 | 100,00 % | | |

Für die Belichtungen der Proben A, B und C wurden folgende photopolymerisierbaren Zusammensetzungen aus den oben aufgeführten monomerhaltigen Mischungen und Farbstoffkonzentrat erstellt. Als Vergleichsbeispiel wurde

die bekannte Rezeptur aus Tabelle 1 ohne das Safranin-O verwendet. Anstatt Safranin-O wurde der Mischung A ebenfalls das Farbkonzentrat FK1 mit Methylenblau hinzugegeben.

Die Proben D, E und F wurden nur mit UV-Licht gehärtet. Deswegen wurde dort anstatt des Farbstoffkonzentrates nur der UV-Photoinitiator Omnirad 1173 zugegeben.

Tabelle 5

| Photopolymerisierbare Zusammensetzung A | | | |
|---|---|---|---|
| **Menge[g]** | **Menge[%]** | **Komponente** | **Name** |
| 5 | 97,09% | VB1 ohne Safranin-O | Monomerhaltige Mischung aus dem Vergleichsbeispiel |
| 0,15 | 2,91% | FK1 | Farbstoffkonzentrat |
| | | | |
| 5,15 | 100,00% | | |

Tabelle 6

| Photopolymerisierbare Zusammensetzung B | | | |
|---|---|---|---|
| **Menge[g]** | **Menge[%]** | **Komponente** | **Name** |
| 5 | 97,09% | MM1 | Monomerhaltige Mischung |
| 0,15 | 2,91% | FK1 | Farbstoffkonzentrat |
| | | | |
| 5,15 | 100,00% | | |

Tabelle 7

| Photopolymerisierbare Zusammensetzung C | | | |
|---|---|---|---|
| **Menge[g]** | **Menge[%]** | **Komponente** | **Name** |
| 5 | 97,09% | MM2 | Monomerhaltige Mischung |
| 0,15 | 2,91% | FK1 | Farbstoffkonzentrat |
| | | | |
| 5,15 | 100,00% | | |

Tabelle 8

| Photopolymerisierbare Zusammensetzung D | | | |
|---|---|---|---|
| **Menge[g]** | **Menge[%]** | **Komponente** | **Name** |
| 5 | 97,09% | VB1 ohne Safranin-O | Monomerhaltige Mischung aus dem Vergleichsbeispiel |
| 0,1 | 1,96% | Omnirad 1173 | Photoinitiator |
| | | | |
| 5,1 | 100,00% | | |

Tabelle 9

| Photopolymerisierbare Zusammensetzung E | | | |
|---|---|---|---|
| **Menge[g]** | **Menge[%]** | **Komponente** | **Name** |
| 5 | 97,09% | MM1 | Monomerhaltige Mischung |
| 0,1 | 1,96% | Omnirad 1173 | Photoinitiator |
| | | | |
| 5,1 | 100,00% | | |

Tabelle 10

| Photopolymerisierbare Zusammensetzung F | | | |
|---|---|---|---|
| **Menge[g]** | **Menge[%]** | **Komponente** | **Name** |
| 5 | 97,09% | MM2 | Monomerhaltige Mischung |
| 0,1 | 1,96% | Omnirad 1173 | Photoinitiator |
| | | | |
| 5,1 | 100,00% | | |

## Zubereitung

Zuerst werden die Farbkonzentrate und die monomerhaltigen Mischungen erstellt. Die jeweiligen Komponenten werden nacheinander in ein Becherglas mit einem Rührmagneten gegeben. Das Becherglas steht dazu auf einer Waage, so dass die flüssigen Stoffe in der richtigen Menge hinzugegeben werden können. Danach wird alles auf einen beheizbaren Magnetrührer auf 120°C erwärmt und verrührt. Die pulverförmigen Stoffe werden mit Hilfe von Wägeschälchen dosiert und unter Rühren der Mischung zugegeben. Die Mischung wird etwa 1h lang bei 120°C gerührt, bevor die Lösung gefiltert und in einer Flasche abgefüllt wird.

Aus den Farbstoffkonzentraten und den monomerhaltigen Mischungen entstehen durch Vermischen (beispielsweise durch Schütteln mit einem Speedmixer oder Verrühren mit einem Rührstäbchen) die erfindungsgemäßen photopolymerisierbaren Zusammensetzungen.

## Belichtungen

Tabelle 11

| Laserbelichtungen | | | | | | |
|---|---|---|---|---|---|---|
| **Material** | **Peak[nm] nach der Laserbelichtung** | **BWG[%] nach der Laserbelichtung** | **Peak[nm] nach der Versiegelung** | **BWG[%] nach der Versiegelung** | **Dicke [μm]** | **Δn** |
| A | 576 | 67 % | 572 | 52 % | 12 | 0,0138 |
| B | 577 | 84 % | 573 | 78 % | 12 | 0,0211 |
| C | 581 | 93 % | 578 | 90 % | 12 | 0,0279 |

Die photopolymerisierbaren Zusammensetzungen A, B und C wurden mit einem Laser mit der Wellenlänge von 577 nm in einem Temperaturbereich von 20°C bis 21°C belichtet. Die photopolymerisierbaren Zusammensetzungen wurden in einem Ofen bei 80°C aufbewahrt und kurz nach dem Auftragen belichtet. Nach der Laserbelichtung wurde mit einem Spektrometer anhand der spektralen Absorptionskurve der Beugungswirkungsgrad (BWG) bestimmt. Die Schichtdicke wurde mit einer digitalen Mikrometer-Bügelmeßschraube gemessen. Danach wurden die photopolymerisierten Zusammensetzungen mit einem UV-Lack versiegelt. Die Härtung des Lackes erfolgte unter einer UV-Brücke mit einer Lichtbogenlänge von 70 mm und einer Leistung von 120 W/cm. Die Bestrahlungszeit betrug 30s. Danach wurden

noch einmal die spektrale Absorptionskurve gemessen und der BWG bestimmt. Anhand der Schichtdicke und des BWG's η wurde das Δn berechnet. Dazu wurde die Kogelnik-Formel (F-1) wie folgt nach Δn aufgelöst.

$$\Delta n = \frac{\lambda}{\pi \cdot d} atanh(\sqrt{\eta}) \qquad \text{(F-2)}$$

Um den belichtungsabhängigen Trübungseffekt zu zeigen, wurden die Proben D, E und F mit unterschiedlich starken UV-Lichtquellen gehärtet. Für die schnelle Härtung wurde wieder die oben beschriebene UV-Brücke verwendet. Obwohl für die Härtung eine wesentlich kürzere Zeit reicht, wurden die Proben 30s lang bestrahlt. Für die langsame Belichtung wurde die Hamamatsu UV-Spot Lichtquelle LC6 verwendet. Das UV-Licht tritt am Ende eines flexiblen Lichtleiters mit der Intensität von 3,5 W/cm$^2$ aus. Die Proben wurden damit 120s lang in einem Abstand von 6cm zur Austrittsöffnung belichtet. Danach wurden sie sicherheitshalber noch einmal 30s lang unter der UV-Brücke nachgehärtet.

Tabelle 12

| UV-Belichtungen | | | | | | |
|---|---|---|---|---|---|---|
| **Material** | **Haze-Wertder langsamen Belichtung** | **Probendicke der langsamen Belichtung [μm]** | **Haze-Wert der schnellen Belichtuna** | **Probendicke der schnellen Belichtung [μm]** | **Haze-Differenz** | **Temperatur [°C]** |
| D | 82 % | 948 | 2 % | 936 | 80 % | 26 |
| D | 89 % | 890 | 70 % | 855 | 19 % | 21 |
| E | 95 % | 952 | 16 % | 928 | 79 % | 21 |
| F | 99 % | 938 | 25 % | 962 | 74 % | 21 |

Die photopolymerisierbaren Zusammensetzungen für die UV-Belichtungen wurden bei einer Raumtemperatur von 21°C aufbewahrt. Nur für die erste Belichtung wurde das Vergleichsmaterial D bei 26°C aufbewahrt und verarbeitet. Die zweite Belichtung bei 21°C mit dem Material D hat trotz schneller Belichtung einen hohen Haze-Wert von 70%, weil bei dieser Temperatur schon die flüssige Formulierung milchig ist.

Für die Haze-Belichtungstests wurden die photopolymerisierbaren Zusammensetzungen mit einer Pipette als dicker Tropfen mittig auf ein Objektglas gegeben und mit einem zweiten Objektglas abgedeckt. Um eine Schichtdicke von ungefähr 0,9mm zu bekommen wurden rechts und links Abstandshalter mit dieser Dicke auf das erste Objektglas gelegt. Das Ganze wurde dann mit seitlich angebrachten Klemmen fixiert.

Nach der Härtung können die Klemmen gelöst und die Glasplatten entfernt werden, so dass die Dicke und der Haze der Photopolymerschicht bestimmt werden kann.

## Belichtunqsaufbau

Der Laserstrahl mit einer gemessenen Leistung von 1,43W wurde mit einem Polygonscanner horizontal aufgeweitet und durch eine Zylinderlinse so gebündelt, dass er eine Belichtungsbreite von 23cm abdeckte. Figur 2 zeigt den schematischen Belichtungsaufbau.

Bezugszeichen in Figur 2:

1 Laser 577nm

2 Spiegel

3 Polygonscanner

4 Zylinderlinse

5 Scanstrahl

6 Scannerspiegel

Die jeweiligen Proben A, B und C wurden mit Hilfe eines verschiebbaren Spiegels mit dieser Linie abgescannt und belichtet. Die Verfahrgeschwindigkeit wurde auf 9mm/s eingestellt. Der Laserstrahl fiel mit einem Winkel von 22° zum Lot auf die Probenoberfläche. Die Figur 3 zeigt den Strahlengang.

Bezugszeichen in Figur 3:

1 Scanstrahl 577nm

2 Scannerspiegel

3 Belichtungsrichtung

4 Belichtungswinkel, 22°

5 Substrat, Glas oder Folie

6 Photopolymer (photopolymerisierbare Zusammensetzung)

7 Master, Spiegelblech

Damit ein Reflexionshologramm entsteht wurde das Probenmaterial auf ein Spiegelblech aufgetragen, welches das Laserlicht zurückreflektiert. Durch die Interferenz des auftreffenden mit dem reflektierten Strahl entsteht parallel zur Oberfläche des Spiegels ein Linienmuster aus hellen und dunklen Stellen. Dieses Interferenzmuster wird vom Material in Form einer Brechungsindexmodulation aufgezeichnet und es entsteht ein sogenanntes Lippmann-Bragg-Hologramm.
Bei der Laserbelichtung befindet sich die Photopolymerschicht zwischen den Spiegelblech und einem transparenten Trägermaterial, z.B. eine PET-Folie oder Glas. Für die Beispiele wurde eine etwa 75μm dicke PET-Folie der Marke Melinex von der Fa. DuPont verwendet. Das Beschichten erfolgte durch Auflaminieren der Folie mit einer Gummiwalze. Die Schichtdicke ergibt sich durch den Anpressdruck, der Temperatur und der Verfahrgeschwindigkeit.
Nach der Laserbelichtung wird das Material noch mit UV-Licht gehärtet. Für den ersten Härtungsschritt verwenden wir einen UV-Blitz mit einer Stärke von 3000 WS. Dies reicht aus um danach das Hologramm mit den Träger vom Blech zu entfernen.
Danach kann das Hologramm noch mit einer UV-Lack Schicht versiegelt werden. Für die Härtung des UV-Lackes verwenden wir eine UV-Brücke mit einer Lichtbogenlänge von 70 mm und einer Leistung von 120 W/cm.

**Messaufbau**

Gemessen wurden die Laserbelichtungsproben A, B und C mit einem Spektrometer (CAS 140 B von der Fa. Instrument Systems) in Durchlicht. Und zwar bei senkrechter Beleuchtung. Da das Hologramm nur die Wellenlänge reflektiert, welche die Bragg-Bedingung erfüllt, ist in der Spektralkurve an dieser Stelle ein deutlicher Absorptionspeak zu sehen.
Aus dem Peakwert $T_{Peak}$ und einem in der Nähe befindlichen Referenzwert $T_{Ref}$ auf der oberen Grundlinie berechnet sich der Beugungswirkungsgrad (BWG) $\eta$ wie folgt:

$$\eta = (T_{Ref} - T_{Peak})/T_{Ref}$$

Figur 4 zeigt die Messkurve mit den entsprechenden Meßpunkten der ersten Belichtung von der Probe C.
Die Tabellenwerte der Belichtungen (Tab. 11) zeigen, dass die Proben B und C bei gleicher Schichtdicke einen höheren Beugungswirkungsgrad und einen besseren $\Delta n$-Wert als die Vergleichsmischung A erreichen.
Die Haze-Werte der UV-Belichtungsproben D, E und F wurden mit einem Hazemeter (haze-gard i von der Fa. BYK) unter der Verwendung einer 4mm Aperturblende nach dem ASTM D 1003 Standardverfahren gemessen. Die Tabellenwerte (Tab. 12) zeigen, dass durch verschieden Belichtungsintensitäten unterschiedliche Trübungen erreicht

werden können. Bei einer Schichtstärke von etwa 0,9 mm kann die Differenz mehr als 70% betragen. Die beiden Messungen der Vergleichsprobe D zeigen, dass die Belichtungstemperatur ebenfalls ein Einfluss hat. Im Gegensatz zu den erfindungsgemäßen Zusammensetzungen E und F ist die flüssige Vergleichsmischung D bei 21°C nicht klar.

## Fertigung

Figur 1 zeigt den schematischen Aufbau einer kompakten Rolle zu Rolle Maschine für die Anfertigung von versiegelten holographischen Kontaktkopien aus den beanspruchten photopolymerisierbaren Zusammensetzungen.

Bezugszeichen in Figur 1:

1 Vorratsbehälter
2 Filter und Entgaser
3 Dosiereinheit
4 Trägerfolie
5 Photopolymer (photopolymerisierbare Zusammensetzung)
6 Trägerfolie mit Hologramm
7 UV-Lack
8 UV-Strahler
9 Trägerfolie mit versiegelten und gebleichten Hologramm
10 Folienabwicklung
11 Laserlicht
12 Master
13 UV-Licht
14 polierte Metalltrommel
15 Folienaufwicklung

## Patentansprüche

**1.** Photopolymerisierbare Zusammensetzung, umfassend:

I) eine erste Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv.

**2.** Photopolymerisierbare Zusammensetzung nach Anspruch 1, umfassend:

I) eine erste Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv,

II) mindestens einen Polyether.

**3.** Photopolymerisierbare Zusammensetzung nach Anspruch 1, umfassend:

I) eine erste Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv,

II) mindestens einen Polyether,

wobei die photopolymerisierbare Zusammensetzung bei einem Standarddruck im Bereich von 15°C bis 150°C flüssig ist.

**4.** Photopolymerisierbare Zusammensetzung nach einem der Ansprüche 1 bis 3, umfassend:

I) 60-95 Gew.-% einer ersten Mischung A, umfassend

a) mindestens ein Monomer M, umfassend mindestens eine ethylenisch ungesättigte Gruppe,
b) mindestens ein Triglycerid und/oder ein modifiziertes Triglycerid,
c) mindestens einen Photoinitiator,
d) mindestens einen aromatischen Aldehyd und/oder aliphatischen Aldehyd und
e) optional ein Additiv,

II) 5-40 Gew.-% mindestens eines Polyethers, wobei die Mengen von I) und II) 100 Gew.-% ergeben.

**5.** Photopolymerisierbare Zusammensetzung nach einem der Ansprüche 1 bis 4, umfassend:

I) 60-95 Gew.-% einer ersten Mischung A, umfassend

a) 70-98 Gew.-% mindestens eines Monomers M, umfassend mindestens eine ethylenisch ungesättigte Gruppe,
b) 0,5-24 Gew.-% mindestens eines Triglycerids und/oder eines modifizierten Triglycerids,
c) 0,1-5 Gew.-% mindestens eines Photoinitiators,
d) 0,1-2 Gew.-% mindestens eines aromatischen Aldehyds und/oder aliphatischen Aldehyds und
e) 0 bis 10 Gew.-% eines Additivs, wobei die Mengen von a) bis e) 100 Gew.-% ergeben, und

II) 5-40 Gew.-% mindestens eines Polyethers, wobei die Mengen von I) und II) 100 Gew.-% ergeben.

**6.** Element, enthaltend eine Komponente, die erhältlich ist durch die Einwirkung von (aktinischer) UV/VIS-Strahlung auf die photopolymerisierbare Zusammensetzung nach einem der Ansprüche 1 bis 5.

**7.** Element nach Anspruch 6, umfassend eine Komponente, die transparente und/oder transluzente Bereiche aufweist.

**8.** Element nach Anspruch 6 oder 7, umfassend ein Hologramm, das erhältlich ist durch die Einwirkung einer holographischen Information tragenden, modulierten Strahlung auf die photopolymerisierbare Zusammensetzung nach einem der Ansprüche 1 bis 5.

**9.** Element nach Anspruch 8, umfassend ein Hologramm, wobei das Hologramm mit einer Versiegelungsschicht versehen ist.

**10.** Element nach Anspruch 9, wobei auf der Versiegelungsschicht ein Quellstoff aufgebracht wird.

**11.** Verwendung des Elements nach einem der Ansprüche 6 bis 8, als Folie, Linse, Gitter, Prisma, Spiegel, Strahlteiler, Diffusor, Oberflächenrelief, Membran, Filter oder Sensor

**12.** Verwendung des Elements nach einem der Ansprüche 6 bis 8 für ein Head-up-Display, eine Datenbrille, ein Lichtleitsystem, ein Spektrometer, ein Detektionssystem, ein Sicherheitselement oder ein Label.

**13.** Verfahren zur Bildung eines lichtbeständigen Hologramms in einer photopolymerisierbaren Schicht auf einer Substratoberfläche, umfassend die Einwirkung einer eine holographische Information tragenden, modulierten Strahlung auf eine Schicht einer photopolymerisierbaren Zusammensetzung nach einem der Ansprüche 1 bis 5.

**14.** Verfahren nach Anspruch 13, wobei die Einwirkung der modulierten Strahlung im Kontaktkopierverfahren erfolgt.

**15.** Verfahren nach einem der Ansprüche 13 oder 14, wobei die photopolymerisierbare Zusammensetzung innerhalb einer Minute aufgetragen und belichtet wird.

**Claims**

**1.** A photopolymerizable composition comprising:

I) a first mixture A comprising

a) at least one monomer M comprising at least one ethylenically unsaturated group,
b) at least one triglyceride and/or a modified triglyceride,
c) at least one photoinitiator,
d) at least one aromatic aldehyde and/or aliphatic aldehyde, and
e) optionally an additive.

**2.** The photopolymerizable composition according to claim 1, comprising:

I) a first mixture A comprising

a) at least one monomer M comprising at least one ethylenically unsaturated group,
b) at least one triglyceride and/or a modified triglyceride,
c) at least one photoinitiator,
d) at least one aromatic aldehyde and/or aliphatic aldehyde, and
e) optionally an additive,

II) at least one polyether.

**3.** A photopolymerizable composition according to claim 1, comprising:

I) a first mixture A comprising

a) at least one monomer M comprising at least one ethylenically unsaturated group,
b) at least one triglyceride and/or a modified triglyceride,
c) at least one photoinitiator,
d) at least one aromatic aldehyde and/or aliphatic aldehyde, and
e) optionally an additive,

II) at least one polyether,
wherein the photopolymerizable composition is liquid at a standard pressure in the range of 15°C to 150°C.

**4.** A photopolymerizable composition according to any one of claims 1 to 3, comprising:

I) 60-95% by weight of a first mixture A comprising

a) at least one monomer M comprising at least one ethylenically unsaturated group,
b) at least one triglyceride and/or a modified triglyceride,
c) at least one photoinitiator,
d) at least one aromatic aldehyde and/or aliphatic aldehyde, and
e) optionally an additive,

II) 5-40% by weight of at least one polyether, the amounts of I) and II) adding up to 100% by weight.

**5.** A photopolymerizable composition according to any one of claims 1 to 4, comprising:

I) 60-95% by weight of a first mixture A comprising

a) 70-98% by weight of at least one monomer M comprising at least one ethylenically unsaturated group,
b) 0.5-24% by weight of at least one triglyceride and/or modified triglyceride,
c) 0.1-5% by weight of at least one photoinitiator,
d) 0.1-2% by weight of at least one aromatic aldehyde and/or aliphatic aldehyde and
e) 0 to 10% by weight of an additive, the amounts of a) to e) adding up to 100% by weight, and

II) 5-40% by weight of at least one polyether, the amounts of I) and II) adding up to 100% by weight.

**6.** Element comprising a component obtainable by exposure of the photopolymerizable composition according to any one of claims 1 to 5 to (actinic) UV/VIS radiation.

**7.** Element according to claim 6, comprising a component having transparent and/or translucent regions.

**8.** Element according to claim 6 or 7, comprising a hologram obtainable by exposing the photopolymerizable composition according to any one of claims 1 to 5 to modulated radiation carrying holographic information.

**9.** Element according to claim 8, comprising a hologram,
wherein the hologram is provided with a sealing layer.

**10.** Element according to claim 9, wherein a swelling material is applied to the sealing layer.

**11.** Use of the element according to any one of claims 6 to 8, as a film, lens, grating, prism, mirror, beam splitter, diffuser, surface relief, membrane, filter, or sensor.

**12.** Use of the element according to any one of claims 6 to 8 for a head-up display, data glasses, light guidance system, spectrometer, detection system, security element, or label.

**13.** A method of forming a light stable hologram in a photopolymerizable layer on a substrate surface, comprising exposing a layer of a photopolymerizable composition according to any one of claims 1 to 5 to modulated radiation carrying holographic information.

**14.** The method according to claim 13, wherein the exposure to the modulated radiation is by contact copying.

**15.** The method according to any one of claims 13 or 14,
wherein the photopolymerizable composition is applied and exposed within one minute.

**Revendications**

**1.** Composition photopolymérisable comprenant

I) un premier mélange A comprenant

a) au moins un monomère M comprenant au moins un groupe à insaturation éthylénique,
b) au moins un triglycéride et/ou un triglycéride modifié,
c) au moins un photoinitiateur,
d) au moins un aldéhyde aromatique et/ou un aldéhyde aliphatique, et
e) en option, un additif.

**2.** Composition photopolymérisable selon la revendication 1, comprenant :

I) un premier mélange A comprenant

a) au moins un monomère M comprenant au moins un groupe à insaturation éthylénique,

b) au moins un triglycéride et/ou un triglycéride modifié,
c) au moins un photoinitiateur,
d) au moins un aldéhyde aromatique et/ou un aldéhyde aliphatique, et
e) en option, un additif,

II) au moins un polyéther.

**3.** Composition photopolymérisable selon la revendication 1, comprenant :

I) un premier mélange A comprenant

a) au moins un monomère M comprenant au moins un groupe à insaturation éthylénique,
b) au moins un triglycéride et/ou un triglycéride modifié,
c) au moins un photoinitiateur,
d) au moins un aldéhyde aromatique et/ou un aldéhyde aliphatique, et
e) en option, un additif,

II) au moins un polyéther,
dans laquelle la composition photopolymérisable est liquide à une pression standard dans la gamme de 15°C à 150°C.

**4.** Composition photopolymérisable selon l'une quelconque des revendications 1 à 3, comprenant :

I) 60-95% en poids d'un premier mélange A comprenant

a) au moins un monomère M comprenant au moins un groupe à insaturation éthylénique,
b) au moins un triglycéride et/ou un triglycéride modifié,
c) au moins un photoinitiateur,
d) au moins un aldéhyde aromatique et/ou un aldéhyde aliphatique, et
e) en option, un additif,

II) 5-40 % en poids d'au moins un polyéther, les quantités de I) et II) donnant 100 % en poids.

**5.** Composition photopolymérisable selon l'une quelconque des revendications 1 à 4, comprenant :

I) 60-95% en poids d'un premier mélange A comprenant

a) 70-98 % en poids d'au moins un monomère M comprenant au moins un groupe à insaturation éthylénique,
b) 0,5 à 24 % en poids d'au moins un triglycéride et/ou un triglycéride modifié,
c) 0,1 à 5 % en poids d'au moins un photoinitiateur,
d) 0,1 à 2 % en poids d'au moins un aldéhyde aromatique et/ou d'un aldéhyde aliphatique, et
e) 0 à 10 % en poids d'un additif, les quantités de a) à e) donnant 100 % en poids, et

II) 5-40 % en poids d'au moins un polyéther, les quantités de I) et II) donnant 100 % en poids.

**6.** Élément contenant un composant qui peut être obtenu en exposant la composition photopolymérisable selon l'une quelconque des revendications 1 à 5 à un rayonnement UV/VIS (actinique).

**7.** Élément selon la revendication 6, comprenant un composant qui présente des zones transparentes et/ou translucides.

**8.** Élément selon la revendication 6 ou 7, comprenant un hologramme pouvant être obtenu par l'exposition de la composition photopolymérisable selon l'une quelconque des revendications 1 à 5 à un rayonnement modulé portant une information holographique.

**9.** Élément selon la revendication 8, comprenant un hologramme, dans lequel l'hologramme est pourvu d'une couche de scellement.

**10.** Élément selon la revendication 9, dans lequel un agent gonflant est appliqué sur la couche de scellement.

**11.** Utilisation de l'élément selon l'une des revendications 6 à 8, comme feuille, lentille, grille, prisme, miroir, séparateur de faisceau, diffuseur, relief de surface, membrane, filtre ou capteur.

**12.** Utilisation de l'élément selon l'une quelconque des revendications 6 à 8 pour un affichage tête haute, des lunettes de données, un système de guidage lumineux, un spectromètre, un système de détection, un élément de sécurité ou une étiquette.

**13.** Procédé de formation d'un hologramme résistant à la lumière dans une couche photopolymérisable sur une surface de substrat, comprenant l'action d'un rayonnement modulé portant une information holographique sur une couche d'une composition photopolymérisable selon l'une quelconque des revendications 1 à 5.

**14.** Procédé selon la revendication 13, dans lequel l'action du rayonnement modulé est réalisée par le procédé de copie par contact.

**15.** Procédé selon l'une des revendications 13 ou 14, dans lequel la composition photopolymérisable est appliquée et exposée en moins d'une minute.

**Figur 1:**

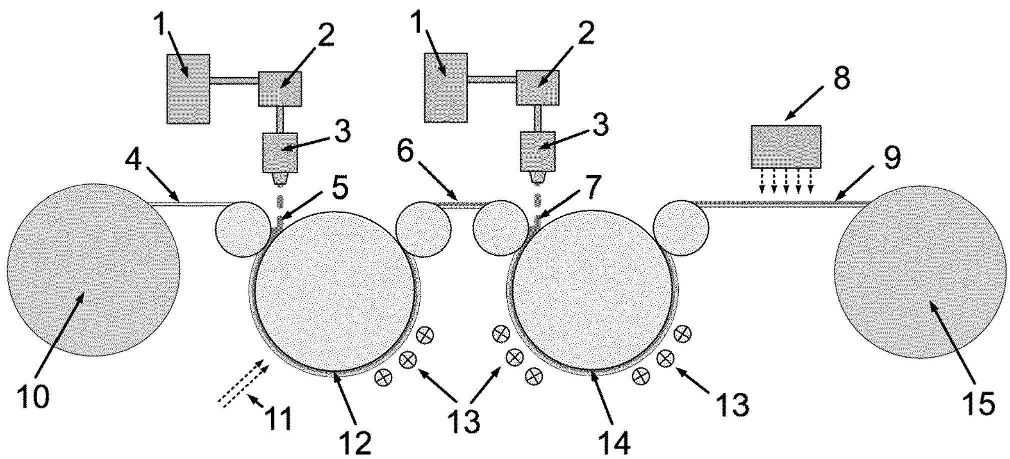

**Figur 2:**

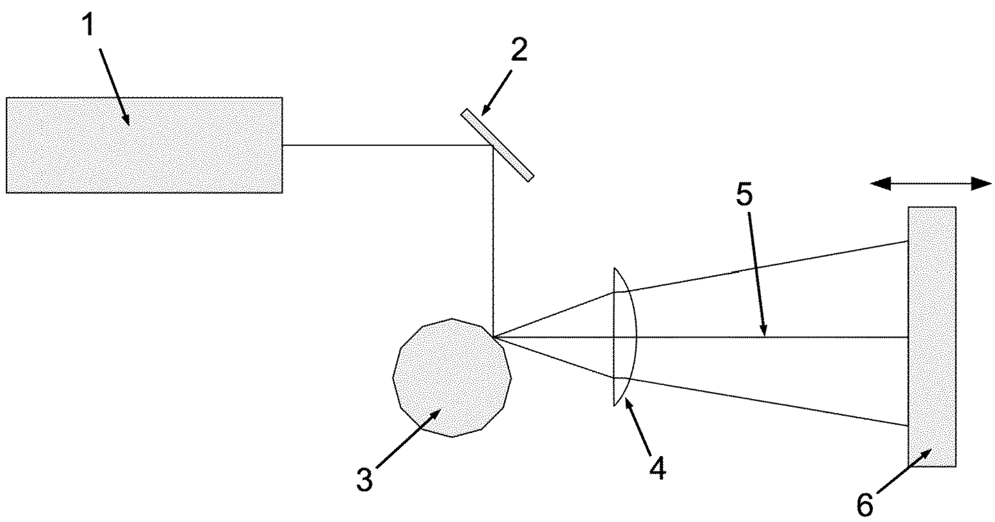

**Figur 3:**

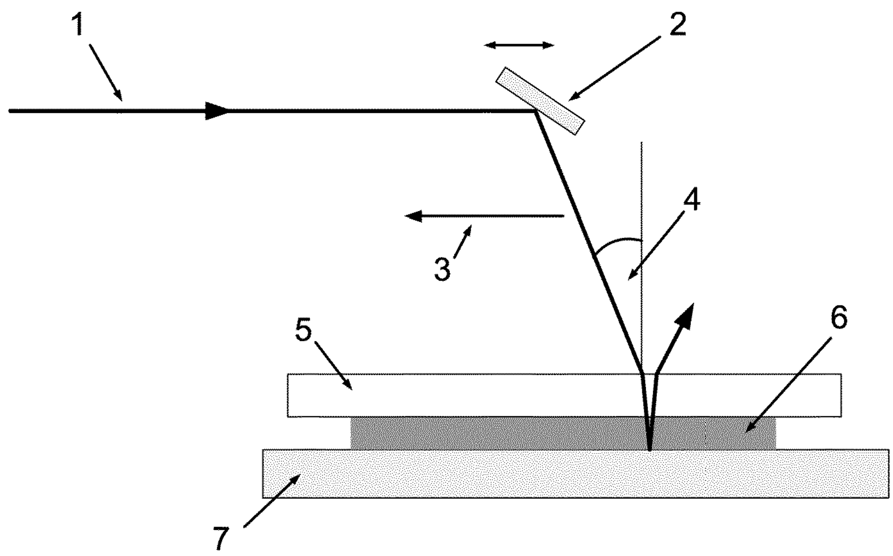

**Figur 4:**

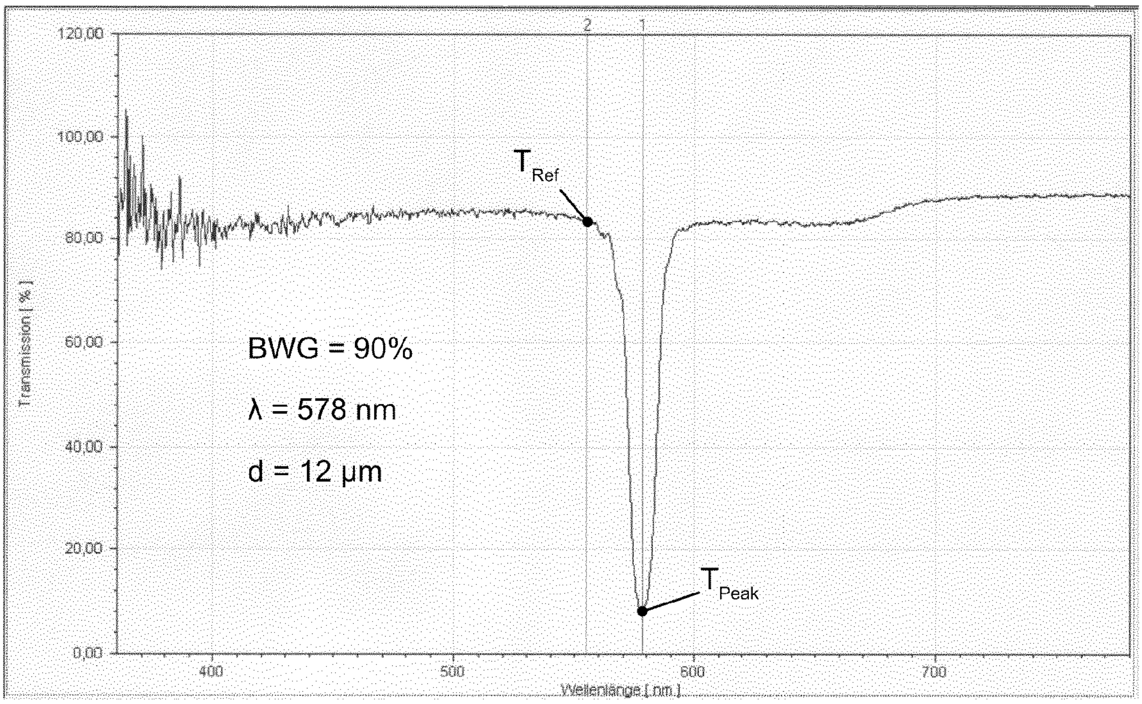
120,00
100,00
80,00
60,00
40,00
20,00
0,00
Transmission [ % ]
400
500
600
700
Wellenlänge [ nm ]
2
1
T Ref
T Peak
BWG = 90%
λ = 578 nm
d = 12 µm

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 0324480 A2
- US 4942112 A
- DE 69032682 T2
- DE 68905610 T2
- US 5759721 A
- EP 1510862 A2
- US 200505891 A1
- EP 123151 A1
- EP 211615 A2
- US 20050068594 A1
- WO 2010091795 A1
- WO 2012062655 A2
- WO 2003036389 A1
- US 2002142227 A1
- US 3993485 A
- EP 2372454 A1
- EP 2219073 A1
- EP 1779196 B1
- US 2760663 A
- US 2850445 A
- US 2875047 A
- US 3097096 A
- US 3074974 A
- US 3097097 A
- US 3579339 A
- US 3427161 A
- US 3479185 A
- US 3549367 A
- US 4311783 A
- US 4622286 A
- US 3784557 A
- US 4341860 A
- US 3554753 A
- US 3563750 A
- US 3563751 A
- US 3647467 A
- US 3652275 A
- US 4162162 A
- US 4268667 A
- US 4454218 A
- US 4535052 A
- US 4565769 A
- US 3854950 A
- US 4168982 A
- US 3390996 A
- US 4326010 A
- DE 60216490 T2
- US 5017406 A
- DE 60030223 T2


### In der Beschreibung aufgeführte Nicht-Patentliteratur


- **HOWARD M. SMITH.** Principles of Holography. Wiley, 1969
- **FRED UNTERSEHER et al.** Holography Handbook: Making Holograms the Easy Way. Ross Books, 1982
- **GRAHAM SAXBY.** Practical Holography. Inst, of Physics Pub, 2004
- **S. M. SCHULTZ et al.** Volume grating preferential-order focusing waveguide coupler. *Opt. Lett.,* Dezember 1999, vol. 24, 1708-1710
- **N. SMIRNOVA.** *Optics in Information Systems,* Februar 2004, 9
- **H. KOGELNIK.** *The Bell System Technical Journal,* November 1969, vol. 48 (9), 2909-2947
- **TIMPE, H.J. ; S. NEUENFELD.** Dyes in photoinitiator systems. *Kontakte,* 1990, 28-35
- **JAKUBIAK, J. ; J.F. RABEK.** Photoinitiators for visible light polymisation. *Polimery (Warschau),* 1999, vol. 44, 447-461
- Dye Sensitized Photopolymerization. **D.F: EATON.** Adv. in Photochemistry. Wiley-Interscience, 1986, vol. 13, 427-487